(19) Europäisches Patentamt
European Patent Office
Office européen des brevets

(11) **EP 4 245 796 A1**

(12) **EUROPEAN PATENT APPLICATION**

(43) Date of publication:
**20.09.2023 Bulletin 2023/38**

(21) Application number: **22162435.6**

(22) Date of filing: **16.03.2022**

(51) International Patent Classification (IPC):
*C08J 3/24* (2006.01)   *C08G 61/12* (2006.01)
*C08J 5/18* (2006.01)   *C08L 25/18* (2006.01)
*C08L 65/00* (2006.01)   *H01L 51/00* (2006.01)

(52) Cooperative Patent Classification (CPC):
**C08J 3/246; C08G 61/126; C08J 5/18; C08L 65/00; H10K 85/113;** C08G 2261/1424; C08G 2261/3223; C08G 2261/794; C08J 2383/04; C08J 2425/18; C08J 2465/00; C08L 25/18; H10K 71/12; H10K 71/861

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **University of Oulu**
**90014 Oulun yliopisto (FI)**

(72) Inventors:
• **Tolvanen, Jarkko**
**90014 Oulu (FI)**

• **Nelo, Mikko**
**90014 Oulu (FI)**
• **Hannu, Jari**
**90014 Oulu (FI)**
• **Juuti, Jari**
**90014 Oulu (FI)**
• **Jantunen, Heli**
**90014 Oulu (FI)**

(74) Representative: **Berggren Oy**
**P.O. Box 16**
**Eteläinen Rautatiekatu 10A**
**00101 Helsinki (FI)**

(54) **AUTONOMOUS SELF-HEALING, TRANSPARENT, ELECTRICALLY CONDUCTING ELASTOMER AND METHOD OF MAKING THE SAME**

(57) The present application relates to a self-healing, electrically conducting elastomer, comprising an electrically conducting phase comprising PEDOT:PSS and an electrically insulating phase comprising a polyborosiloxane-based polymer and a polydimethylsiloxane-based polymer. The present application also relates to a method for manufacturing the self-healing, electrically conducting elastomer.

Fig. 1a

EP 4 245 796 A1

**Description**

Technical field

The present application relates to autonomous self-healing, transparent, electrically conducting elastomer and methods of making the same.

Background

Self-healing materials are synthetically-created substances that can have the ability to repair damages, such as cracks or cuts, to themselves. The self-healing materials in principle may be divided into two systems, autonomous and nonautonomous systems. Self-healing materials belonging to the autonomous system have the build-in, inherent self-healing ability, that is triggered without intervention. Self-healing materials belonging to the nonautonomous systems may require intervention through an external stimulus (light, temperature change, etc.) to initiate the healing process.

Autonomously self-healing materials that can be can be considered as conductors and/or resistors (in terms of their electrical conductivity) have been proposed. For example, such self-healing materials may be based on one- or two dimensional nanomaterials, (semi) conducting polymers, inorganic or electrolyte salts, ionic liquids to form continuous or co-continuous elastomers, hydrogels, or ionic gels made by either directly blending or embedding conductive organic or inorganic materials to elastomeric matrices to achieve conductivities in the range of $10^{-2}$-$10^{-8}$ (S cm$^{-1}$). After damage, the mechanical properties and electrical conductivities of the materials may recover to $\approx$90-95% of their original capacity, however repeated recovery is therefore often less than $\approx$90%.

In addition, conventional non-healable materials often face the challenge of achieving good stability, stretchability, transparency and electrical conductivity at the same time as these properties are often mutually exclusive due to improper design strategies. It has been very difficult to even to achieve a flexible, transparent conductors that are bendable, while having good cyclic stability and deformability. With non-healable materials typically randomly interconnected, metallic, and carbonaceous percolation networks are used to prepare mechanically more compliant transparent conducting films (in comparison to a rigid and brittle alternatives).

Because deformability of the soft, flexible or stretchable conductors usually rely on the intrinsic properties of the (conductive) elastomers and/or nanomaterials, there can be significant trade-offs or issues with many of the important properties, such as mechanical durability and deformability.

Self-healing conductors, which achieve transparency, sufficient electrically conductivity, and are considered mechanically stable often require an external stimulus or an energy input trigger, such as temperature, to initiate a self-repair.

Furthermore, in the prior art, autonomously self-repairing transparent conductors with an electrical conductivity greater than 0.01 S cm$^{-1}$ and capable of restoring $\approx$100% their pristine conductivity when repeatedly damaged do not yet exist.

As mentioned above, percolation nanowire networks are usable even for self-healing conductors when large deformations are not required, but they have significant drawbacks for more elastic conductors, and are fundamentally limited to recover portions of their pristine mechanical and electrical properties upon mechanical damages as covalent bonds in the nanomaterials are permanent broken (even when partially embedded into self-healing polymer matrices). Therefore, there is a desire not only to have improved stretchability for large deformations but more importantly efficient and autonomous self-repair in transparent conductive elastomers, especially for the applications relating to soft electronics and robots.

Summary

It is an object of the present invention to provide a new class of transparent, tough, stretchable, electrically conducting material with mechanical damage resistance through autonomous self-healing functionality in universal conditions, while being mechanically stable.

The invention is based on autonomously self-healing elastomer capable of restoring its pristine properties under different conditions and elastically recovering from extremely large deformations due to entropic recovery of properties. The electrically conducting elastomer according to the present invention, having an unique phase-separated structure, and localized heterogeneity, said elastomer comprising at least PEDOT:PSS, polyborosiloxane-based polymer and a polydimethylsiloxane-based polymer, has been made electrically conducting with an anisotropic electrical conductivity, when for example in the form of a film, up to more than 1 S cm$^{-1}$, which is about $10^2$- $10^8$ times higher than the known similar materials or non-transparent self-healing conductors (excluding any based on liquid metals and wrinkled nanomaterial conductors patterned on elastomeric substrates). Conductivity varies when measured along axes in different directions, or planes, due to phase-separation. Because anisotropy is related to phase-separated morphology in the material after solidification, the anisotropy is not constant between different compositions (as morphology and phase-separation in conductor may change). Conductivity ratios between vertical ($\sigma\|$ ; along PEDOT-rich nanofibrils), parallel ($\sigma^{\perp}$; perpendicularly to PEDOT-rich nanofibrils), and through ($\sigma^{=}$ , from conducting plane to insulating plane) may vary with different compositions. In this description, anisotropy in terms of electrical conductivity is expressed as the ratio of vertical to parallel conductivity ratio ($\sigma\| / \sigma^{\perp}$) on conducting plane. The vertical conductivity of the material is superior to that of pristine PEDOT:PSS films ($\approx$0.1-1.0 S cm$^{-1}$). The material is capable of spontaneously self-repairing mechanical and electrical properties upon physical damages without intervention or energy input trigger. That is, for example, it can completely restore to the pristine electrical conductivity (100%) when fully bisected. Due to supramolecular interactions, the material also has excellent adhesion capacity in dry and wet conditions to materials with varied surface roughness and/or chemistries. The material is capable to autonomously form an electrical and mechanical contact through supramolecular interactions. The material shows a complex anisotropic swelling underwater that may enable water-sensitive or moisture-triggered soft actuators with smart sensing capabilities.

In addition to serve as a conductor, the material according to the present invention can also be used directly as an active sensing element in soft sensor components, as it is able to react sensitively to various type of stimuli, such as changes in temperature, humidity or mechanical stresses. The mechanical and electrical properties of the material can be independently or simultaneously adjusted to fit the needs by modifying the composition and/or structure of the material. The solution-processable conductor is compatible with the manufacturing methods of printed electronics to fabricate various forms of functional structures and device architectures. The material can be widely utilized on a variety of transparent touch-sensitive surfaces, transparent electrodes for components, such as electroluminescent displays, or directly as (transparent) sensors in wearable electronics, bioelectronics, prosthetics and robotics. The material can be used in particular in, but not limited to, printed, flexible or stretchable electronics as circuit boards and as electrical wiring, or connections, and as a base material to prepare electrodes for wide variety of soft and/or flexible and/or stretchable electronic components, e.g. actuators, energy harvesters, sensors, capacitors, conductors, resistors, etc. It is possible to obtain completely autonomously self-healing components and devices based on the material, provided that other materials of which the components or devices are made of have self-healing functionalities, and no significant mismatches exist in terms of mechanical, chemical or thermal properties. At the moment, none of the self-healing materials in the prior art are as versatile as the novel material according to the present invention with respect to the above-mentioned applications.

The spontaneously self-repairing, transparent, electrically conducting elastomer according to the present invention is characterized by, while in the form of a multilayered film, comprising

- a first layer comprising an electrically conducting phase, comprising PEDOT:PSS; and
- a second layer comprising an electrically insulating phase, comprising polyborosiloxane-based polymer and a polydimethylsiloxane-based polymer; preferably, the insulating phase comprises an interpenetrating polymer network of polyborosiloxane-based polymer and a polydimethylsiloxane-based polymer.

Such a new material, the spontaneously self-repairing, transparent, stretchable, and electrically conducting elastomer, is in the present description also simply referred as a conductor according to the invention.

The new material according to the present invention may be made by a method comprising

- providing a first mixture comprising PEDOT:PSS and a solvent, said first mixture contributing to an electrically conducting phase of the elastomer,
- providing separately following components, which contribute to an electrically insulating phase of the elastomer, based on the total weight of the electrically insulating phase:

  - 0.1 - 5 wt.% of boron trioxide ($B_2O_3$),
  - 65 - 90 wt.% of hydroxyl-terminated polydimethylsiloxane (PDMS-OH), and
  - 5-30 wt.%, when measured in combined, of polysiloxane precursors, being

    - a first composition comprising a siloxane base, and
    - a second composition comprising a siloxane crosslinker, wherein the ratio by weight of the first composition and the second composition is 1:1 to 50:1,

- mixing the $B_2O_3$, the PDMS-OH, a surfactant, the first mixture, and the polysiloxane precursors, thereby obtaining a second mixture,
- allowing reaction to take place in the second mixture by setting the second mixture at an elevated temperature ranging from 50 °C to 150 °C, endpoints inclusive, thereby obtaining a solidified elastomer.

The method according to the present invention is a lot simplified and efficient, as compared to the known methods for manufacturing similar materials in the prior art.

The obtained elastomer may be in the form of a film. For example, the second mixture may be spread on a substrate with a release film before the step of allowing reaction to take place, which include curing of the components, and then continue the method under the elevated temperature.

The self-healing and conductive elastomer according to the present invention has an unique morphology and structure formed by an electrically conducting phase and electrically insulating phase. The electrically conducting phase comprises PEDOT:PSS, and the electrically insulating phase comprises a composition, based on a polyborosiloxane-based polymer and a polydimethylsiloxane-based polymer, of an interpenetrating networks and cross-links that contribute to unprecedented combination of mechanical, optical, electrical and self-healing properties.

The self-healing and conductive elastomer according to the present invention, having a tunable anisotropic electrical conductivity in a range of $\approx 10^{-5}$ - 10 S cm$^{-1}$ or even more than 2 S cm$^{-1}$, is capable being stretched more than 50 times of its initial length. On such occasion, a residual strain may exist in freestanding conductor if elongated over >2,000% strain (with the amount of irreversible deformation or residual strain being in some cases less than 100%). Further, the material possesses all in one excellent electrical conductivity, transparency, stretchability, toughness, elasticity, autonomous self-healing characteristics, adhesive properties, water-triggered anisotropic swelling, and moisture barrier ability which properties are difficult to achieve simultaneously in the known single material in the prior art (while any of the properties can be further tuned with composition or processing conditions). With the material according to the present invention, it is possible to make devices that meet the waterproof requirements according to the standard IP67 (IP Code, or Ingress Protection Code, sometimes referred to as International Protection Code). Furthermore, the self-healing ability of the material according to the present invention may remain even in challenging conditions, e.g. low or high pressures and temperatures, and even underwater, saline, acidic or alkaline conditions according to some preferred embodiments.

One important advantage of the material according to the present invention is that it can act directly as a transparent sensing layer or element in soft sensor components, even in applications where extremely large stretches (>1,000% strain) are required. The sensitivities of transparent sensor materials in the prior art are often insufficient, while they cannot withstand very large deformations without considerable irreversible deformation due to viscoplasticity of the elastomeric substrates when the stress is removed. The sensitivity of the material, according to the present invention, to various stimuli (e.g. temperature, humidity, mechanical stress) can be adjusted through composition, morphology and structure of the material to control mechanical and/or electrical properties of the conductor, as well as by using geometric structural designs for coupling/decoupling stimulus. Some geometrical designs are particularly great for improving strain-insensitivity of soft conductors, e.g. meander and serpentine designs, while some other geometrical designs, e.g. finger electrode structures, have a critical role in improving accuracy of a sensor to measure a specific stimulus, such as tensile strain, temperature, or humidity. The solution-processable conductor allows a wide variety of industrial usability, such as in the printed, flexible or stretchable electronics, soft robots or actuators, and/or as base material for electrodes in soft sensor components or directly as a sensing layer or element in soft sensor component.

The main embodiments are characterized in the independent claims. Various embodiments are disclosed in the dependent claims. The embodiments and examples recited in the claims and the specification are mutually freely combinable unless otherwise explicitly stated.

Brief description of the drawings

Fig. 1a and Fig. 1b are schematic diagrams of the principle of the method according to the present invention.

Fig. 2a to Fig. 2e show the data about different amounts of added solvent (DMSO) of the elastomeric connectors according to the present invention.

Fig. 3a to Fig. 3e show the data about different drying weights of the elastomeric connectors according to the present invention.

Fig. 4 shows the data about different mixing times of the elastomeric connectors according to the present invention.

Fig. 5a to Fig. 5c show the data about different ratios of insulating phase to conducting phase of the elastomeric connectors according to the present invention.

Fig. 6a to Fig. 6b show the characteristics of the elastomeric connectors according to the present invention; Fig. 6c shows optical micrographs of pristine PEDOT-rich and pristine PBS as comparison.

Fig. 7 shows the data about different amounts of added surfactant of the elastomeric connectors according to the present invention.

Detailed description

The present invention relates to a self-healing, electrically conducting elastomer, comprising an electrically conducting phase comprising PEDOT:PSS and an electrically insulating phase comprising a polyborosiloxane-based polymer and a polydimethylsiloxane-based polymer. The present invention also relates to a method for manufacturing the self-healing, electrically conducting elastomer.

In this specification, percentage values, unless specifically indicated otherwise, are based on weight (w/w). If any numerical ranges are provided, the ranges include also the upper and lower values. The open term "comprise" also includes a closed term "consisting of" as one option.

The term "autonomous self-healing" or "autonomously self-healing" or the like as used herein refers to the ability to initiate the self-healing process without external intervention or energy input trigger. External intervention or trigger may be a temperature change to higher than the room temperature (e.g. 30 °C or more) and/or other stimuli such as pressure, chemicals, humidity, moisture, etc. External intervention or trigger may also be a mechanical force to be applied to initiate self-healing, e.g. when aligning cut/fractured surfaces, regardless of temperature. Thus, an autonomous self-healing material can heal without intervention at any given room temperature, e.g. 0 - 30 °C.

The term "universal self-healing" or the like as used herein refers to the self-healing ability in not only ambient conditions, but also various other conditions, such as at those with low or high pressure and temperatures, under water, acidic or alkaline conditions, etc.

The term "interpenetrating network" or "interpenetrating polymer network" or the like as used herein refers to materials comprising two or more networks which are at least partially interlaced on a polymer scale but not covalently bonded to each other. The network cannot be separated unless chemical bonds are broken. Simply mixing/blending two or more polymers does not create an interpenetrating polymer network. The term "interpenetrating PBS-PDMS" thus refers to PBS-PDMS having a interpenetrating network structure, rather than a blend of PBS and PDMS.

The term "pristine elastomers" as used herein refers to undamaged or unconditioned, i.e. without any applied mechanical stimulus beforehand, elastomers.

Unless explicitly indicated otherwise, the term "conductivity" used herein for expressing the property of the material according to the present invention refers to (anisotropic) direct current electrical conductivity.

There are several desired properties for autonomously self-healing materials that can be employed as conductors or resistors. For example, how much/fast they stretch without breaking; how well and how quickly they recover shape after tension; how quickly, efficiently, and under what conditions they self-heal; how ambient conditions and changes thereof affect the mechanical, electrical, and self-healing properties; transparency of materials at the wavelength of visible light at the non-stretched or stretched states; their mechanical properties (stiffness, toughness, etc.) are, among other things, important aspects of properties. On the other hand, the electrical conductivity should be as large as possible for electrical wiring or contacts, or electrodes in many (soft) electronic components, but it should be also possible to be adjusted for other applications, such as sensors or electromagnetic interference shielding (i.e., increased resistivity of the conductor beneficial). Stability of the conductor is important, in terms of strain, temperature and humidity. For electrodes, the conductivity should be constant despite mechanical stress or environmental stimuli, while in sensors it is the other way around. In sensors, a more sensitive a material or structure for a specific stimuli is desirable for improved stimuli-coupling and overall performance of the sensor(considering other sensor parameters would be constant). Thus, it becomes particularly important to be able to tune the sensitivity/insensitivity of a material to specific stimuli if the material is proposed for both electrodes and sensors.

However, known autonomously self-healing conducting elastomers, in the prior art are able to achieve only some of the above-mentioned properties, while many of the important properties are compromised if any of the properties is optimized. For example, mechanically stable and robust self-healing materials are often not able to self-repair in underwater or universal conditions and may have very long repair times. In addition, many autonomously self-healing materials are not resistant moisture, for example, because water molecules can penetrate and interact the weak dynamic bonds; also, the mechanical strength and Young's modulus of said materials significantly decreases as the amount of absorbed water molecules increases. It can also lead to significant swelling (weight and dimensions change noticeably) and inability to initiate a self-repair in aqueous medium or in presence of moisture as the water molecules prevent wetting and diffusion of dynamic bonds (such as those based solely on hydrogen bonds). Furthermore, known self-healing materials (independent of their electrical properties), capable of functioning underwater or in universal conditions, in the prior art have insufficient mechanical stability and robustness, for example they have often low mechanical strength, and low toughness.

Most importantly, in the prior art, there are no transparent conductors capable to be stretched in considerable amounts, e.g. up to 50 times of their original length, and return most of their original size when the stress is removed.

The mechanical behavior of the autonomously self-healing conductor according to the present invention differs significantly from other similar materials. There can be both linear and non-linear relationship between stress and strain as the conductor tends to minimize conformational entropy upon deformation (dependent on the strain rate and conditions to which the conductor is exposed to). Linear relationship is found in some embodiments according to the present invention, with a certain strain rate, for example 10-20 mm/s, and to certain extent/limit, such as 1000% - 2500% strain. The complex stress-strain behavior differs from most of the self-healing elastomers that are electrically conducting or non-conducting. Typically, the ultimate stress at optimal composition-dependent strain rate increases with the increased amount of PEDOT-rich nanofibrils (if other composition parameters are kept constant). The conductor according to the present invention shows both temperature and speed-induced toughening which a very unique feature and relates partially to the nature of the dynamics bonds in the polyboronsiloxane (with contribution of other factors, such as PEDOT-rich nanofibrils). The unique stress-strain behavior is due to the special morphology, structure and composition of the multiphase self-healing conductor according to the present invention, which differs substantially from other autonomously self-healing materials.

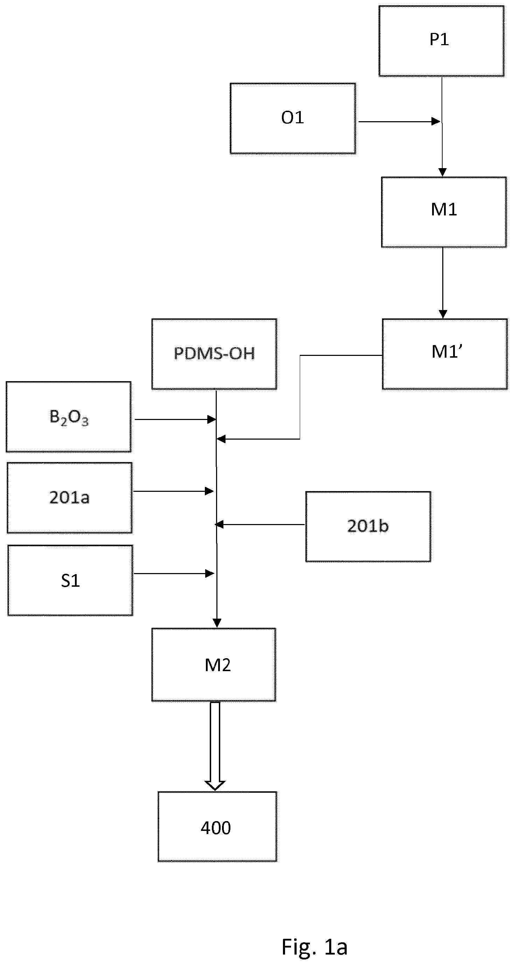

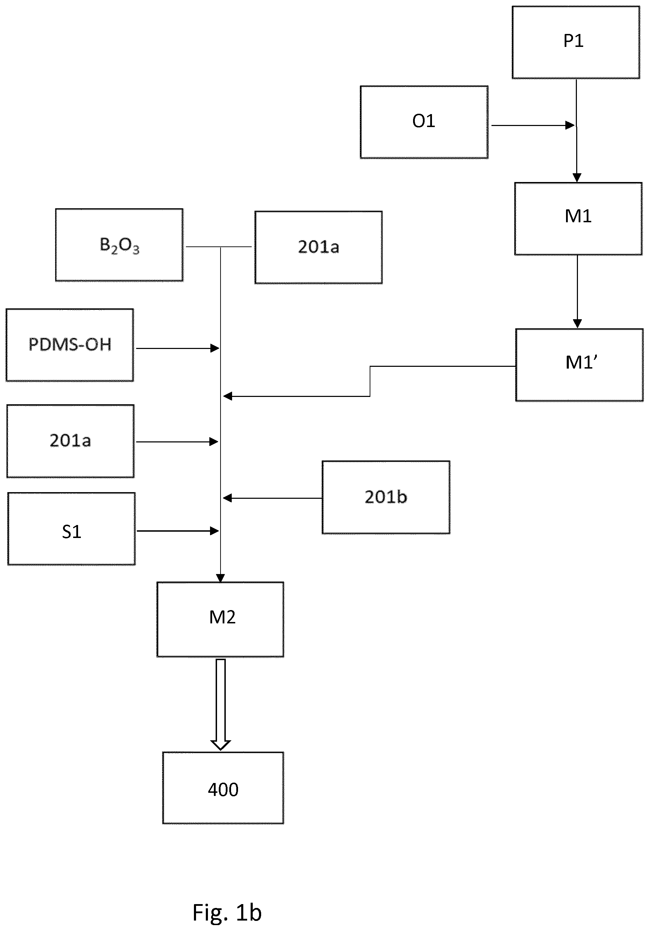

Figures 1a and 1b are flow charts that schematically illustrate exemplary methods according to the present invention. It is to be noted that the order of adding ingredients are not bound to the illustrated order in the figure unless explicitly indicated otherwise in the description.

The self-healing, transparent, electrically conducting elastomers according to the invention, or obtainable according to the method of the invention, are hereunder, as well as in the claims, denoted as elastomer 400, or conductor 400.

With reference to Fig. 1a, a self-healing, transparent, electrically conducting elastomer 400 according to the present invention may be made according to a method comprising

- providing a first mixture M1' comprising PEDOT:PSS and a solvent O1, said first mixture contributing an electrically conducting phase of the elastomer,
- providing separately following components, which contribute to an electrically insulating phase of the elastomer, with respect to the total weight of the electrically insulating phase,

  - 0.1 - 5 wt.% of boron trioxide ($B_2O_3$), preferably in the form of nanoparticles,
  - 65 - 90 wt.% of hydroxyl-terminated polydimethylsiloxane (PDMS-OH)
  - 5 - 30 wt.%, when measured in combined, of polysiloxane precursors 201, being

    ◦ a first composition 201a comprising a siloxane base, preferably a polymer containing at least one ethylenically unsaturated group, and preferably also a branched siloxane-based polymer, and optionally a surface modifier which preferably contains at least one ethylenically unsaturated group;
    ◦ a second composition 201b comprising a siloxane crosslinker, wherein the ratio by weight of the first composition 201a and the second composition 201b is 1:1 to 50:1;

- mixing the $B_2O_3$, the PDMS-OH, the first composition 201a, the second composition 201b, a surfactant S1, and the first mixture M1', thereby obtaining a second mixture M2,
- allowing reaction to take place in the second mixture M2 by setting the second mixture M2 at an elevated temperature ranging from 50 °C to 150 °C, endpoints inclusive, thereby obtaining the elastomer 400. Said reaction involves solidification, and the obtained elastomer is solidified elastomer.

The self-healing and conductive elastomer 400 according to the present invention has an unique phase-separated structure with localized heterogeneity, formed by at least an electrically conducting phase and at least an electrically insulating phase. The electrically conducting phase comprises PEDOT:PSS, and the electrically insulating phase comprises an unique composition, based on an interpenetrating networks of a polyboronsiloxane-based polymer and a polydimethylsiloxane-based polymer, containing cross-links that contribute to unprecedented mechanical properties. The polyboronsiloxane-based polymer contributes to a soft phase and the polydimethylsiloxane-based polymer contributes to a hard phase of the electrically insulating phase.

The obtained elastomer 400 may be in the form of a film. For example, the second mixture M2 may be spread on a surface of a release substrate before the step of allowing reaction to take place, which may include curing of the components, and then continue the method under the elevated temperature.

Poly(3,4-ethylenedioxythiophene) polystyrene sulfonate (PEDOT:PSS) is a polymer mixture of two ionomers. One component sodium polystyrene sulfonate and part of the sulfonyl groups thereof are deprotonated and carry a negative charge. The other component poly(3,4-ethylenedioxythiophene) (PEDOT) is a $\pi$-conjugated polymer and carries positive charges and is based on polythiophene. Together the charged macromolecules form a macromolecular salt. PEDOT:PSS contributes to the electrical conducting phase of the elastomer 400. Also, under the effect of solvent O1,which is explained further below, the formed PEDOT-rich nanofibrils may simultaneously improve all mechanical properties of the elastomer 400, such as strength, toughness, extensibility, and temperature and/or speed-induced toughening, and self-healing characteristics through increased diffusivity.

In the method according to the present invention, the first mixture M1' may be obtained by preparing an aqueous dispersion P1 comprising PEDOT:PSS, adding the solvent O1 into the aqueous dispersion P1, thereby obtaining a mixture M1, and drying the mixture M1, thereby obtaining the first mixture M1'. During drying, the solvent O1,such as DMSO, opens up the insulating PSS shell covering conductive inner domain, and then coalescences PEDOT:PSS microgel particles by facilitating a transition from coiled core-shell structure to linear long chains, which can form larger crystalline PEDOT-rich domains and leads to interchain entanglements between PSS chains during processing. This improves the electrical conductivity of the material, i.e. elastomer 400.

In the method according to the present invention, in the mixture M1, the amount of the solvent O1 may be more than 0 vol.%, for example up to 50 vol.%, based on the volume of the aqueous dispersion P1; or the amount of the solvent O1,such as DMSO, may be more than 0 wt.%, for example up to 32 wt.%, based on the weight of the aqueous dispersion P1.

Formation and interconnection between PEDOT-rich nanofibrils and density of the network can be significantly improved by particularly higher amounts of solvent O1,such as DMSO, for example 12 vol.% or more, which maintains the linearity as the amount of the isolate phase increases. It is observed that a higher content of the solvent facilitates a better conductivity and self-healing properties.

In terms of conductivity, the amount of the solvent O1,such as DMSO, may be preferably around 16 vol.%, based on the volume of the aqueous dispersion P1 (with assumption that the density of P1 is close to 1 g cm$^{-3}$), or around 13 wt.%, based on the weight of the aqueous dispersion P1, as the electrical conductivity does not seem to increase when the amount of the solvent O1 is above said preferred value.

In terms of self-healing properties, on the other hand, it is observed that, with an even higher content of the added solvent, such as DMSO, for example close to 30 wt.% or 48 vol.%, the diffusivity of the elastomer 400 can increase, and the elastomer 400 may self-heal faster after a transition period (i.e., as amount of solvent increases above 30 wt.%). It is also observed that localized heterogeneity and composition gradient in the elastomer 400 increases with the amount of added solvent, thus contributing a better self-healing ability if above the transition region. The solvent O1,acting as a secondary dopant, has a plasticizing effect that decreases the glass transition temperature ($T_g$) in the localized regions of the heterogenous network leading to overall softening of the conductor as $\pi$-conjugated domains become more flexible. This facilitates a larger free volume and improved chain flexibility in the conductor that are important for the number of possible chain conformations and phase-arrangements upon entropic recovery of properties after the initiation of the self-repair process, or upon large deformations, (when transition from equilibrium (steady state) to metastable state(s)), and eventually regaining the equilibrium state. Due to above-mentioned reasons, the resulting material is not only significantly softer, but more stretchable when the amount of solvent increases.

The solvent O1 may be evaporated out of the material, i.e. elastomer 400, at an elevated temperature during the process. Thus, the final product, i.e. elastomer 400, may be substantially free of solvent O1 or contain a small trace of the solvent O1. Nevertheless, the optimal amount of solvent depends what the application of the material is. Because the solvent, such as DMSO, affects morphology and structure formation, thus mechanical-, electrical-, and self-healing properties (for example, by facilitating a better electrical percolation in the PEDOT-rich nanofibril network). Therefore, it affects also the anisotropy in terms of electrical conductivity. For instance, in some sensor applications, different anisotropy may be better to achieve a higher strain sensitivity to a specific direction or better sensitivity regardless of the direction of elongation. Thus, anisotropic conductivity becomes particularly relevant in multidirectional strain sensors, and also important for other components that need to improve their one- or multi-directional strain-insensitivity.

The solvent O1 may be an organic solvent, preferably a polar solvent, for example sugar alcohols, sulfoxides such as dimethyl sulfoxide (DMSO), ethylene glycol (EG), tetrahydrofuran (THF), or glycerol. The solvent O1, acting as secondary dopant, in the mixture comprising PEDOT:PSS transforms the PEDOT:PSS micelles into nanofibril in which the conducting PEDOT chains are better interconnected. Secondary dopants do not directly increase the number of charge carriers in the $\pi$-conjugated polymer as dopants do in metals or intrinsic semiconductors. Aqueous colloidal dispersion forms micellar microstructure with hydrophobic PEDOT-rich core and hydrophilic PSS-rich shell, i.e. PSS chain coiled around PEDOT core. This type of tertiary structure is known to be the origin of poor conductivity in pristine PEDOT:PSS films. Basically, PSS adds counter-ion and soluble template that improves chemical stability and solubility of PEDOT in aqueous solutions. The PSS chains are swollen in water. The PEDOT and PSS are held together by ionic interaction, which can be weakened with secondary dopants leading to, for instance, coalescence of microgel particles and phase-separation between PEDOT and PSS upon solidification.

Alternatively, in the method according to the present invention, the solvent (O1) may further comprise a water-soluble compound comprising acidic anions, such as ionic salt such as lithium bis(trifluoromethanesulfonyl)imide (LiTFSI), to further increase the conductivity. Ionic compounds that contain sulfonate or sulfonimide anions are known dopants for π-conjugated polymers, such as PEDOT:PSS. The compounds should have good water solubility (and thus to PEDOT:PSS), and contain acidic anions (for charge transfer doping). Therefore, LiTFSI is a particularly good option due to its excellent water solubility. It is found that in such a case, the solvent O1 shall not be an organic solvent (such as DMSO) as it leads to microgel particle aggregation, thus formation of flakes. Thus, the solvent O1 may be, for example, comprising LiTFSI dissolved in deionized water. The amount of ionic salt can be as low as, for example, 50 mg with 100 mg DI water for ≈2.3 g of the aqueous dispersion P1 comprising PEDOT:PSS. Such modification increases the anisotropic electrical conductivity nearly two-fold to range of ≈1.4-2.0 S cm$^{-1}$ (in comparison to that with 13 wt.% or 16 vol.% of DMSO). It is proposed that even higher amount of ionic salt can be added, and the conductivity would then increase with the amount of ionic salt increasing. Dopants may convert higher portion of benzoid moieties in PEDOT to quinoid structure through oxidative charge transfer doping resulting in more planar backbone which then contributes to charge delocalization and higher packing order (i.e., leading to better charge transport). At the same time these ionic compounds can act as plasticizers and promote morphology changes (formation of fibrous morphology) leading always to enhanced stretchability and decreased Young's modulus in the conductor, but also in some cases better self-healing characteristics if the proposed material fulfils the intrinsic requirement for self-healing of having a stimuli-responsive component or network (i.e., has the ability to initiate self-repair cycle) (similar to addition of DMSO). The main idea of plasticizers is to reduce the glass transition temperature by increasing free volume. This will induce a morphological changes, such as relaxation of polymer chains, and may allow formation of more interconnected network of PEDOT-rich chains. With plasticizer the material becomes less stiff and more deformable, while it can promote self-healing characteristics by changing localized chain flexibility and glass transition temperatures.

In the method according to the present invention, the surfactant S1 is preferably an amphiphilic surfactant, more preferably a nonionic surfactant, for example polyethylene glycol tert-octylphenyl ether (Triton™ X-100). The amphiphilic surfactant weakens, inter alia, ionic interaction between conducting PEDOT and insulating PSS, causing phase separation and enhancing crystallization of PEDOT segments (similarly to secondary dopants). The amount of the surfactant S1 may be at least 0.1 wt.%, for example up to 15 wt.%, based on the weight of the aqueous dispersion P1. It has been surprisingly found, that the amount of surfactant has no effect on electrical conductivity, in forming the second mixture M2; regardless of the amount of surfactant, electrical conductivity is similar with similar processing parameters and composition. However, it has also been surprisingly found, that a higher amount of the surfactant S1 improves the overall stability of the final product, in terms of mechanical and electrical properties in ambient conditions with different levels of humidity, due to the more interconnected hydrophobic and hydrophilic domains due to amphiphilic nature of the surfactant. With smaller amount of surfactant present, such as 1.3 wt.%, the diffusivity and moisture sensitivity is significantly higher. This means that a conductor made with less amount of surfactant, such as 1.3 wt.%, becomes significantly softer underwater (in comparison to its dry state at elevated temperatures), but the conductor with a high content of surfactant, such as 13 wt.%, may remain more stiff. This similar effect is seen at ambient conditions when a conductor is exposed to ambient humidity. A conductor with less surfactant, such as 1.3 wt.%, may considerably soften within a few minutes (dependent on the actual temperature and humidity present). However, a conductor with more surfactant, such as 13 wt.%, maintains its dry state properties significantly longer. Also, the effect of humidity is not as significant when the exposure time is long enough to have an effect to the mechanical properties. Another function the amphiphilic surfactant is to allow PEDOT-rich nanofibrils to be homogenously dispersed into hydrophobic siloxane-based elastomer before solidification. The surfactant reduces interfacial tension, i.e. force of attraction, and adsorbs at interfaces between conducting and insulating phase. Thus, it allows a blend of thermodynamically incompatible phases that will then eventually phase-separate through multiple interaction mechanisms and factors contributing to the final phase-separation in the multiphase system. Without amphiphilic surfactant, the π-conjugated polymer and the insulating self-healing phase cannot be mixed with each other. For example, since PEDOT is hydrophobic and the PSS is hydrophilic, when amphiphilic surfactant is directly added to PEDOT:PSS dispersion, the head of the surfactant attaches to PSS and tail to PEDOT, which can facilitate formation of nanofibrils (similar to DMSO), and in the case of multiphase material system contributes to the final morphology and structural formation by connecting hydrophobic and hydrophilic chain segments.

In the method according to the present invention, the first mixture M1', compared to the weight of the mixture M1, may have a decreased weight in a range of from -64 wt.% to below 0 wt.%, preferably from -60 wt.% to -15 wt.%, more preferably between from -40 wt.% to -20 wt.%, most preferably between from -20 wt.% to -35 wt.%, expressed according to the formula below

$$\text{(weight of the first mixture M1' – weight of the mixture M1)} \div \text{(weight of the mixture M1)} \times 100\%.$$

Such a decreased weight is also referred as "drying weight" in the present application. For example, if the weight of the mixture M1, comprising the solvent O1 and the aqueous dispersion P1 comprising PEDOT:PSS at the start is 10 grams, and after drying step the weight of the obtained first mixture M1' is 6.8 grams, then the decreased weight, or drying weight, is -32%. The drying weight has significant influence on the viscosity of the final mixture. With more drying, the viscosity of the solution increases (similarly as by increasing mixing time). The final "surface finish" is better with more significant drying, but too excessive amount of drying, such as drying weight being under -65 wt.%, may lead to significant conductivity decrease and poorer self-healing properties. Especially this is true with longer mixing time and larger amount of surfactant, such as Triton X-100, which could be that it leads to better overall dispersion of the PEDOT-rich nanofibrils to insulating phases, thus as a consequence a poorer localized heterogeneity and phase separation. Generally, within the defined range, less drying and/or shorter mixing time facilitate an improved heterogeneity and phase-separation of the final product, i.e. elastomer 400 (leading to not only to better mechanical, electrical and self-healing properties, but improved stability of the material system).

In the method according to the present invention, PEDOT:PSS may have a dry matter content of 1.1 to 1.3 wt.% based on the weight of the aqueous solution P1, and PEDOT:PSS may have a PEDOT to PSS ratio of in a range between 1:2.5 and 1:20, endpoints inclusive. The conductivity is tunable by adjusting the PEDOT to PSS ratio; the larger the content of PEDOT is, the better the conductivity is. Preferably, the PEDOT:PSS has a dry matter content of 1.3 wt.% with the PEDOT to PSS ratio 1:2.5.

In the method according to the present invention, the aqueous dispersion P1 may further comprise one-dimensional metallic or carbonaceous fillers, such as metallic nanowires, such as copper or silver nanowires, or carbon nanotubes (CNTs). Carbon nanotubes are hexagonal and tubular carbon structures made of graphene with a diameter in the range of nanometers. The carbon nanotubes may be COOH-functionalized carbon nanotubes in an amount of more than 0 and up to 3 wt.%, more preferably 0.75 -1.5wt.%, such as 1 wt.%, based on the weight of the aqueous dispersion P1. The carbon nanotubes form with PEDOT-rich nanofibrils a hybrid electrical percolation network, which is particularly advantageous with thin film geometries due to increased conductivity in the phase-separated final product, when in the form of film with a thickness below 50 micrometres. These carbon nanotubes can be either multiwalled (MWCNT) or single walled (SWCNT). Preferably, the carbon nanotubes are functionalized, for example with carboxylic acid (-COOH), to achieve a better dispersion into polymers. In COOH-functionalized carbon nanotubes, the carboxyl groups are bonded to ends and sidewalls of CNTs. For instance, incorporation of small amount, such as more than 0 and up to 3 wt.%, of COOH-functionalized carbon nanotubes significantly increases conductivity while it does not affect optical, mechanical or self-healing properties. Preferably the amount of the COOH-functionalized carbon nanotubes is around 0.75-1.5 wt.%, and more preferably around 1 wt.%, based on the weight of the aqueous dispersion P1 comprising PEDOT:PSS. An amount of more than 3 wt.% is less desirable as optical transparency of the film may decrease. These hybrid networks may be particularly good for sensors for tuning their anisotropic electrical properties and stimuli-responsiveness.

Thus, the elastomer 400 according to the present invention may comprise one-dimensional nanomaterial, such as metallic nanowires or carbon nanotubes. The elastomer 400 comprising metallic nanowires may be manufactured by the following steps:

- spray coating a solution with nanowires to a substrate
- evaporation solvent from the solution
- coating with multiphase material, i.e. the second mixture M2
- film solidification at elevated temperatures
- peel off the elastomeric film from the substrate (the nanowires would then be partially embedded in the film on one plane).

The phase-separation would be controlled so that the conducting surface is formed against the nanowires/substrate during solidification.

Alternatively, the elastomer 400 in the form of a film may be pressed on the sprayed nanowires so that the conducting surface sticks to the nanowires/substrate, and then the film is removed together with the nanowires from the substrate.

In the method according to the present invention, the ratio of the total weight of the $B_2O_3$, the PDMS-OH and the optionally also polysiloxane precursors, i.e. the insulating phase, to the total weight of the aqueous solution P1, the organic solvent O1 and the surfactant S1, i.e. the conducting phase, is between 1:1 to 10:1, for example between around 2:1 to 10:1, preferably between around 2:1 to 5:1, and more preferably around 2:1. Within the above-defined range, e.g. between 2:1 to 10:1, larger amount of conducting phase leads to better conductivity (up to a certain point) due to induced morphological changes with the result of denser nanofibril network and more well-defined phase-separation for improved charge carrier transport; also, the stability increases with the increased amount of PEDOT-rich nanofibrils. However, excessive amount of conducting phase, e.g. a ratio equal to 1:1, may lead to decrease of electrical properties and self-healing properties due to suppressed phase-separation and heterogeneity as the material system favors a more homogenous structure formation upon solidification.

However, a high solvent O1 content, such as DMSO, with lower amount of conducting phase may achieve similar or significantly better conductivity than lower amount of solvent O1 with larger amount of conducting phase. The reason is that, the phase-separation is partially result of the solute-solvent interactions (in addition to other factors) during dry annealing or evaporation of the solvent at elevated temperatures. For instance, with approx. 14 vol.% of solvent O1,such as DMSO, the conductivity is still rather good even though the insulating to conducting phase ratio increases to 5:1. The insulating to conducting phase ratio 5:1 can still have a sufficient phase-separation and connectivity in the nanofibril network. While in other composition with solvent O1,such as DMSO, in the range 0-10 vol.% the conductivity is nearly ten times lower with similar insulating to conducting phase ratio (5:1). A higher DMSO content favors formation of PEDOT-rich nanofibrils during initial drying. Preferably, the ratio of the total weight of the $B_2O_3$, the PDMS-OH and optionally also the polysiloxane precursors, to the total weight of the aqueous solution P1, the organic solvent O1 and the surfactant S1, is 2:1, and the solvent O1,such as DMSO, is in a range between 14 vol.% and 28 vol.%, endpoints inclusive. As noted above, a higher amount of solvent O1 results in elastomer 400, which can have an increased force sensitivity due to increased softness (similar to other compositions that result in softer material), thus more suitable for manufacturing soft sensors.

Also, when the above-mentioned ratio is smaller than 6:1, such as smaller than 5:1, or smaller than 4:1, or smaller than 3:1, the resulting elastomer 400 may be more stable as the formed structure can freeze in place which prevents degradation of the structure in long time scales. In this case, the structurally stability also means that the properties are stable in ambient conditions and the behaviour of the elastomer is not dominated by the diffusivity of the dynamic phase, while the material is more stable also in high humid conditions/underwater. A formation of nanofibril network that occupies a larger volume promotes mechanical robustness and entropic recovery of properties in the conductor, and may supress the diffusivity of the soft phase and prevent degradation, (but this is also dependent on other composition parameters). These become more pronounced when said ratio is lower, or when the amount or the volume of PEDOT-rich nanofibrils is more. The improved mechanical robustness and structural stability can be seen at any strain rates or conditions, respectively. Structurally stable materials allow more uniform deformation in the conductor be preventing flow of the soft phase, and as consequence, larger conformational entropy change does not significantly change upon exposure to humidity / in presence of water molecules, or show as strong anisotropic swelling underwater. On the other hand, the less stable materials may function as water-sensitive actuators.

The electrically insulating phase of the elastomer 400 according to the present invention comprises an unique composition, based on interpenetrating networks of a polyborosiloxane-based polymer and a polydimethylsiloxane-based polymer, preferably made by reacting boron trioxide, hydroxyl-terminated polydimethylsiloxane and polysiloxane precursors as disclosed in the present invention. Preferably the boron trioxide is in the form of nanoparticles.

A nanoparticle, as defined herein, refers to a particle of matter that is between 1 and 500 nanometers (nm) in diameter, which can be observed by using, for example, a transmission electron microscope. In the present invention, the number-average diameter of $B_2O_3$ nanoparticles is preferably 50 - 200 nm, more preferably between 80 - 100 nm. $B_2O_3$ nanoparticles provide a large contacting area for the reaction and thus contribute to the reaction efficiency significantly, when compared with non- nanoparticles of $B_2O_3$. As mentioned, such diameters may be measured microscopically, for example measured from microscopic images, for example by using electron microscopy, such as SEM etc.. Thus, in the case of using $B_2O_3$ nanoparticles, less $B_2O_3$ is need. It is found that the amount of $B_2O_3$ used affects the mechanical properties in the product, i.e. the resulting self-healing elastomer 400. For example, while other factors are kept constant, by using 1% of $B_2O_3$ in the method, the product is more stretchable than, for example, using 5% of $B_2O_3$, based on the total weight of the boron trioxide, the hydroxyl-terminated polydimethylsiloxane and the polysiloxane precursors. Thus, by adjusting the amount of $B_2O_3$ a variety of products having different mechanical properties according to the practical applications can be achieved. Thus, preferably, the $B_2O_3$ is in an amount of 0.10 - 3.00 wt.%, more preferably 0.65- 1.90 wt.%, and even more preferably 0.75 -1.40 wt.%, for example 0.85 wt.%, based on the total weight of the boron trioxide, the hydroxyl-terminated polydimethylsiloxane and the polysiloxane precursors. On the other hand, further decreasing the amount of $B_2O_3$ (from 0.85 wt.%) can be beneficial to a certain extent in the multiphase elastomeric conductor as the number of dynamic cross-links can be decreased (i.e., may affect moisture sensitivity and stability which is further dependent on the composition, morphology, and structure of a conductor).

The length of the polymer chain of PDMS-OH used affects the mechanical and self-healing properties through increasing amount of entanglements and effective amount "cross-links" in the insulating phase, and thus the produced final product, i.e. self-healing, conductive elastomer 400 to allow a variety of applications. For instance, as the molecular weight (M) (i.e., polymer chain length) increases, the interdiffusion decreases in the dynamic phase. This is explained by reptation model describing a motion of a single chain. The time required ($T_r$) for a single polymer chain to escape its tube increases with molecular weight (with relationship of $T_r \propto M^3$). Also, the polymer chain length controls viscosity ($\eta_0$) of the polymer (proportional to experimentally verified value of $\eta_0 = M^{3.4}$ after the molecular weight (M) becomes more than the critical entanglement molecular weight ($M_c$)). Also, the effective amount of net- /junctions points (or "cross-links") actually increase as the length of the polymer chains increases as strands occupy "larger" three-dimensional space in a state of the highest conformational entropy (that is without stress) (with the amount of entanglements also increasing).

The PDMS-OH has a kinematic viscosity ranging from 850 - 25000 cSt, more preferably 18000-22000 cSt, at 25 °C. A devise, such as Haake Mars 40, complying measurement standard ASTM D2196-20, may be used for determining the kinematic viscosity. It is found that using PDMS-OH having a lower kinematic viscosity, such as 850-1150 cSt, results a softer final elastomer regardless of the other processing conditions (due to small number of entanglements). By increasing the kinematic viscosity of PDMS-OH used, it is found that the elastomer becomes increasingly more robust as elastic Young's modulus (E) and stress at break ($\delta_{break}$) increase by over 10-fold (viscosity of PDMS-OH increasing from 850-1150 cSt to 18,000-22,000 cSt.) Regardless of the processing conditions or composition, the polymer strength and extensibility increases with viscosity of PDMS-OH to a certain extent (to a plateau after which the entanglements due not further contribute to increase of mechanical properties).

The amount of PDMS-OH used in the present method affects the self-healing ability of the final product, i.e. the self-healing and conductive elastomer 400. In order to achieve sufficient self-healing ability while maintain good mechanical properties of the self-healing elastomer, the amount of PDMS-OH used in the present method can be 65 - 90 wt.%, based on the total weight of the boron trioxide, the hydroxyl-terminated polydimethylsiloxane and the polysiloxane precursors. Preferably, the PDMS-OH used is in an amount of 69-89.5 wt.%, for example 69.3 - 89.1 wt.%, preferably 75 - 88 wt.%, more preferably 77 - 86 wt.%, for example 84 wt.%.

As mentioned, the self-healing elastomer 400, interpenetrating PBS-PDMS, comprises an interpenetrating polymer network of a polyborosiloxane-based polymer (PBS) and a polydimethylsiloxane-based polymer (PDMS). In the interpenetrating polymer network structure, the PBS, produced by reacting $B_2O_3$ and PDMS-OH, is a supramolecular polymer having surprisingly large amount of dynamic bonds, or dipole-dipole interactions, that contribute to the intrinsic self-healing ability. The supramolecular dynamic bonds, namely dative bonds between boron and the oxygen in the Si-O groups, allow self-healing ability to be maintained without deterioration over time. The intrinsic ability of the supramolecular polymer to repair mechanical damage repeatedly is generally based on the continuous ability of dynamic bonds to regenerate between polymer chains when damaged. PBS is a non-Newtonian fluid, whose dynamic viscosity is affected by, among other things, the shear stress. PBS can behave like a solid elastic substance or like a viscous liquid. This depends on the rate of tension, e.g. uniaxial elongation rate. The material is therefore dimensionally unstable due to diffusivity of the material (given a certain time the entanglements become un-entangled which then relates to the molecular weight in PBS), in which case the material does not retain its shape at room temperature when in place. The method of the present invention utilizes a multiphase-strategy, where the idea in the insulating phase is to take advantage of the soft and hard phases. In this case, the soft phase fulfills the intrinsic requirement to be capable of initiating a self-repair (through reversible dynamic interactions), while the hard phase provides much needed mechanical stability (i.e., prevents diffusivity of the soft phase ), as well as allows material conversion to elastomer with strong entropic recovery of properties. The first composition 201a and the second composition 201b according to the present invention contribute to the hard phase after curing. In other words, the electric insulating phase of the elastomer according to the present invention comprises a soft phase and a hard phase.

According to the present method, $B_2O_3$, PDMS-OH, a first composition 201a comprising a siloxane base, a second composition 201b comprises a siloxane crosslinker, and the surfactant S1, may be added into the first mixture M1' and mixed, to form a second mixture M2. The ingredients, i.e. $B_2O_3$, PDMS-OH, the first and second compositions 201a, 201b, the surfactant S1, and the first mixture M1', may be all mixed at the same time; alternatively, $B_2O_3$ may be mixed with PDMS-OH first, followed by mixing in the first composition 201a, the surfactant S1, and the first mixture M1'. In some preferred embodiments, the $B_2O_3$ may be firstly mixed with a small amount of the first composition 201a homogeneously, followed by mixing the PDMS-OH and the remainder of the first composition 201a, as illustrated in Fig. 1b; this way the second mixture M2 can be achieved more efficiently. It is advantageous to mix in the second composition 201b in the last before other ingredients are mixed, as it facilitates the following reaction efficiency and a well-formed interpenetrating polymer network of the final product.

According to the present invention, the first composition 201a comprises a siloxane base. A siloxane base may also be referred as siloxane base resin, is a siloxane-based polymer containing vinyl groups, or in other words, a siloxane-based polymer containing at least one ethylenically unsaturated group. In some embodiments, the siloxane base is dimethylvinyl-terminated dimethylsiloxane. The first composition 201a can further comprise a surface modifier, for example dimethylvinylated and trimethylated silica. The first composition 201a can further comprise a branched siloxane, preferably containing at least one ethylenically unsaturated group, such as 1 1,1,5,5,5-hexamethyl-3,3-bis[(trimethylsilyl)oxy]-trisiloxane.

According to the present invention, the second composition 201b comprises a siloxane crosslinker. A crosslinker, or a crosslinking agent, is a molecule which has at least two reactive ends capable of chemically attaching to specific functional groups of the polymer chains. The siloxane crosslinker as disclosed herein is capable of connecting to the polymer chains of the siloxane base comprised in the first composition 201a to create a cross-linked polymer network.

The second composition 201b serves as a curing agent for the reaction between the first composition 201a and the second composition 201b. In some embodiments, the siloxane crosslinker is dimethyl, methylhydrogen siloxane. The second composition 201b can further comprise the same siloxane base as in the first composition 201a, for accelerating the cross-linking reaction. The second composition 201b can further comprise a surface modifier, for example dimethylvinylated and trimethylated silica. The second composition 201b can further comprise network formation agent, for example methylvinylcyclosiloxane.

Preferably, the reaction between the first composition 201a and the second composition 201b results in polydimethylsiloxane. Preferably, the resulting polydimethylsiloxane has a low glass transition temperature ($T_g$) equal to or below -55 °C, or equal to or below -125 °C, or equal to or below -140 °C, to contribute in intrinsic healing and allow efficient healing to take place in cold environments. The added $B_2O_3$, may on the other hand increase the glass transition temperature of the insulating phase close to -100 °C. It must be further pointed out that the localized heterogeneity and interpenetrating network (i.e., introduced composition gradients) in the insulator and conductor may lead to broadened and shifted $T_g$ of individual phases with also the contribution of plasticizers in the case of a conductor.

The first composition 201a and the second composition 201b, i.e. polysiloxane precursors 201, contribute to the hard phase of the electrical insulating phase of the multi-phase strategy according to the invention. The combined amount of the compositions 201 thus affects the properties of the final product. Thus, the amount can be adjusted according to the actual needs. The combined amount of the first composition 201a and the second composition 201b according to the present invention is advantageously in a range of 10 - 30 wt.% , based on the total weight of the boron trioxide, the hydroxyl-terminated polydimethylsiloxane and the polysiloxane precursors. It is observed that an amount increasing to close to 30 wt.% affects the self-healing ability of the non-conducting elastomer noticeably. An amount of more than 30 wt.% decreases significantly the self-healing ability of the final product and thus is less desirable in the case of insulator. On the other hand, an amount of less than 15 wt.%, especially less than 10 wt.%, affects noticeably the mechanical properties, such as Young's modulus, of the final product and thus is less desirable. When the amount of composition 201 is less than 15 wt.%, the elastic modulus, toughness and elasticity decreases, while the self-healing rate could increase. In this case it is possible to change the other processing conditions and or compositions (such as amount of $B_2O_3$) to restore the desired properties.

The weight ratio between the first composition 201a and the second composition 201b affects also the behavior and mechanical properties of the final product. In general, the weight ratio of the first composition 201a and the second composition 201b being in a range of 1:1 to 50:1 result in a final product with good mechanical properties, while a range between 2.5:1 and 10:1 is more preferable. By increasing the proportion of the second composition 201b, the cross-linking structure of the material increases, leading to reduction of the elasticity/tensile strength and decrease of the hardness/Young's modulus.

According to the present invention, the mixing for obtaining the second mixture M2 may be for at least 5 minutes, for example up to 90 minutes, preferably up to 60 minutes; more preferably, the mixing time is for between 10-20 minutes. It is surprising found that the mixing time has significant influence on the conductivity and self-healing properties through induced morphological changes and structure formation. The relatively shorter mixing time enables significantly higher conductivity and improved self-healing characteristics due to increased phase-separation and heterogeneity. For instance, when other conditions were kept constant, the anisotropic electrical conductivity can be ≈1.0 S/cm with ≈10 min of mixing time and ≈0.7 S/cm with ≈60 min mixing time, when the amount of surfactant, such as Triton X-100, is 3.7 wt.%. With larger amount of surfactant, the effect is more significant: the conductivity can be ≈1.0 S/cm with ≈10 min of mixing time and ≈0.5 S/cm with ≈60 min of mixing time. But what is particularly interesting, is that the conductivity does neither increase with the amount of Triton X-100 (if added later on) nor depends on the amount with small mixing times. With longer mixing time, the phase-separation becomes poorer, and as consequence, also the stability is poorer and self-repair can be significantly slower. Increased amount of surfactant may facilitate a more favorable entropy of mixing resulting in either distinct or similar phase-separation, but always less heterogenous morphology on macroscale upon solidification (which as a consequence affects the self-healing characteristics but favours mechanical stability of the material system).

All conductors with insulating to conducting phase ratios in the range of 2:1 - 10:1 recover 11.2 - 120.1% of pristine toughness in ambient conditions in ≈1-2 minutes after the alignment of cut-surfaces (with any composition parameters and processing conditions).

According to the present invention, the reactions between the ingredients, i.e. $B_2O_3$ with PDMS-OH, and the first composition 201a with the second composition 201b, happens at an elevated temperature ranging from 50 °C to 150 °C. Meanwhile, phase-separation is formed through decomposition that is a complex combination of multiple factors and mechanisms affecting which are dependent on the composition and processing conditions of the conductor. The reaction temperature for $B_2O_3$ and PDMS-OH affects how quickly and strongly the nanoparticles react with the hydroxyl group (OH) of the PDMS-OH. Thus the temperature can be adjusted according to the actual needs. An elevated temperature is needed for the hydroxyl group of PDMS-OH to leave and the subsequent reaction to happen. Generally, a reaction temperature of at least 50 °C is sufficient. On the other hand, although $B_2O_3$ and PDMS-OH may react at a higher temperature up to e.g. 200 °C, the reaction temperature is preferably not more than 150 °C, more preferably not more than 120 °C. It is observed that at a temperature of more than 150 °C, it is more challenging to form a film with a uniformed thickness, because air bubbles form in the material and cause a porous surface. Also, temperatures above 150°C would lead to PDMS chain randomly scissored by $B_2O_3$. Because this chain scission is a random process, it is difficult to obtain well-defined molecular structures and specific mechanical properties for PBS. The structure difference between PBSs made below and above 150 °C is observable under FTIR spectra. On the other hand, the reaction time and the reaction temperature of the first composition 201a and the second composition 201b may vary. It is noted that the reaction can take place even at room temperature to a certain degree. However, it is found that curing in an elevated temperature, such as 50-150 °C, for a longer period of time, for example 4 hours (and then remainder of the time in a room temperature), contributes the improved elastic modulus and strength at break of the self-healing elastomer, as compared to curing in the same elevated temperature for a shorter period of time, for example 2 hours (and then remainder of the time in a room temperature). In some preferred embodiments the reaction takes place at 60-120 °C for about 10 hours. In general, curing time or reaction time should increase as the temperature decreases. For instance, it seems better to react the polymers in 70 °C for 24 hours than 12 hours. When a certain reaction time is achieved there seems to be no benefit nor disadvantage to continue the reaction at elevated temperature. Considering the suitable reaction temperature ranges for both $B_2O_3$ with PDMS-OH, and the first composition 201a with the second composition 201b, the preferable temperature is thus in a range of 50 °C - 150 °C, for example 60 °C, 65 °C, 70 °C, 80 °C, 90 °C, 100 °C, 110 °C, 115 °C, 120 °C, or 130 °C, and most preferably 70 °C. Reaction between ingredients generally happens at the same time, thus leads to a more complex interpenetrating polymer network.

It is found that by decreasing the curing temperature (from 120 °C to 70 °C) and ratio of polymer base 201a to curing agent 201b (from 10:1 to 5:1) there is two-fold increase for strength at break ($\delta_{break}$) and elongation at break ($\varepsilon_{break}$) values. This may be explained by the increased phase-separation in the interpenetrated network.

In some embodiments according to the present method, wherein, with respect to the total weight the $B_2O_3$, the PDMS-OH and the polysiloxane precursors, the $B_2O_3$ is 1 wt.% and has an average diameter of 80 nm measured microscopically, for example by using electron microscopy, such as SEM, the PDMS-OH is 85 wt.% and has a kinematic viscosity of 18,000-22,000 cSt at 25 °C measured according to standard ASTM D2196-20, the polysiloxane precursors 201 is 14 wt.%, wherein the ratio by weight of the first composition 201a and the second composition 201b is 5:1; and wherein the reaction is taken place at 70 °C.

In view of above, the factors that may be used for tuning the desirable properties of the final product of the method according to the present invention include:

- phases that are included in the multiphase system (especially hard phase);
- type of substrate (for instance, a silicon wafer or glass may favor different type of structure formation than a PET-based release film due to solute-substrate interactions);
- film thickness after deposition to a substrate;
- drying weight (affects the amount of water in the dispersed conducting phase);
- mixing time;
- whether the multiphase materials contains PEDOT-rich nanofibrils or not
- type and total amount of solvent (taking the evaporation temperatures and the solubility parameters into account);
- type and amount of amphiphilic surfactant (evaporation temperature and how it interacts with the phases
- solute-solute interactions (depends on the compositions and temperature);
- solute-substrate interactions;
- temperature during cross-linking.

If the composition is kept relative similar, the most important factors are the drying weight, mixing time, cross-linking temperature and film thickness.

According to the present invention, the self-healing, electrically conducting elastomer 400 may be in the form of a multilayered film and comprise

- a first layer comprising an electrically conducting phase, comprising PEDOT:PSS; and
- a second layer comprising an electrically insulating phase, comprising a polyborosiloxane-based polymer and a polydimethylsiloxane-based polymer; preferably, the insulating phase comprises an interpenetrating polymer network of polyborosiloxane-based polymer and a polydimethylsiloxane-based polymer.

The elastomer 400 has an unique phase-separate structure with localized heterogeneity, which can be observed microscopically, for example, by using optical micrograph, or atomic force microscopy. Such elastomer 400 is obtainable by the above-mentioned methods according to the present invention.

The self-healing, electrically conducting elastomer 400 in the form of a multilayered film according to the present invention may be laminated, i.e. stacking two or more films together, through dynamic interactions, and by carefully controlling the layer-by-layer structure, thus to achieve freestanding films. For instance, laminated films may be formed by gently pressing two films against each other so that the electrically conducting planes form the outer surfaces of the multilayered film (top and bottom). It is advantageous to combine multiple films after cross-linking is complete rather than curing a thicker film, in order to achieve the desired properties with with freestanding films.

In addition to films, the self-healing, electrically conducting elastomer 400 according to the present invention may be used to coat or impregnate other materials, which can be obtained at the same time as naturally self-repairing and conductive. Available methods, including but not limited to, depositing coating, spray coating, dip coating, dispersion coating, and etc. These coating methods as well as other coating methods applicable for the present invention are known to the skilled person in the art.

The materials to be coated may include, for example, foam or porous materials with a closed or open cell structures, which serves as a scaffold, i.e. template or supporting structure, for the coating. In this case, the scaffold may also be pre-tensioned, i.e. laminated, which can affect the porosity of the microstructure before coating. Heterogenous and open cell microstructures in the scaffolds may favor self-healing and mechanical properties, and force sensing capabilities of the final product. The structure of the foams or porous materials, and the functional fillers or coatings they contain can already affect their final properties at baseline. Said scaffold may be a polymer or composite foam of any kind, for instance, compose partially of melamine, nanocellulose, silicone, or polyurethane. It is possible, for example, that a two component polyurethane foams would be coated or impregnated with the conductor. In this case, the material mixture M2 is made as usual, but before the step of allowing reaction to take place at the elevated temperature, the foam material is (repeatably) dipped in the mixture M2. The foam (which can include filler particles or other coating) is then repeatedly pressed to remove the excess mixture M2 from the cell structure. After removing excess coating, the foam is heated at an elevated temperature in a range of 50 °C - 150 °C, thereby obtaining the elastomer 400 coated foam. The thickness of the coating and volume fraction of the conductor in the foam can be controlled by further repeating the process. Thus, there is provided according to the present invention an electrically conductive, self-healing polymer or composite foams, comprising a porous scaffold, for example polyurethane foam, coated with a composition comprising PEDOT:PSS, a polyborosiloxane-based polymer and a polydimethylsiloxane-based polymer, preferably an interpenetrating polymer network of polyborosiloxane-based polymer and a polydimethylsiloxane-based polymer.

The self-healing, electrically conducting elastomer 400 in the form of a multilayered film according the present invention, having at least one of the following properties, which are detectable from the direct product of the method according to the present invention:

- an anisotropic electrical conductivity in a range of $10^{-8}$ - 10 S cm$^{-1}$ , such as $10^{-5}$ - $10^{-2}$ S cm$^{-1}$; and/or an electrical anisotropy in range of 0.5 - 25 (i.e., ratio of vertical to parallel conductivity on conducting plane);

- anisotropic swelling underwater;

- capability of being stretched more than 20 times of initial length and recover with insignificant residual strain (less than 100%, such as 0 to 100%);

- recovers of 10-120% of toughness (independent of the composition) after mechanical damage in ambient conditions in ≈10-200 seconds;

- blue colored (due to incorporation of PEDOT:PSS);

- optical transmittance (i.e., transparency) of the conductor increases with strain;

- capability to self-heal in low or high atmospheric pressures, for example, from 6 to 110 kPa, and temperatures ranging from -100° to 200 °C, saline, acidic and alkaline conditions, underwater and in combinations of these;

- recovers ≈100% of conductivity after mechanical damage;

- temperature and speed-induced toughening with toughness in the range 1.0-100 MJm$^{-3}$, or 10-70 MJm$^{-3}$, or in some cases even exceeding 100 MJm$^{-3}$ at optimal conditions;

- Young's modulus in range of 0.1 - 0.5 MPa with 1 - 20 mm s$^{-1}$ strain rate (in the low strain region);

- stretchability in the range of 500-5,000% strain with 10 mm s$^{-1}$ strain rate, or in some cases even exceeding 5,000% strain.

Table 1 shows some of the above-mentioned properties.

**Examples**

• Example 1 - manufacturing a self-healing, electrically conducting elastomer

Materials:

PEDOT:PSS aqueous dispersion, product name PH 1000, from Ossila DMSO, Sigma-Aldrich 41640-M, ACS reagent, ≥ 99.9%
Triton X-100, Sigma-Aldrich Triton™ X-100, laboratory grade
Hydroxyl terminated poly(dimethylsiloxane) (PDMS-OH) with kinematic viscosities of 18,000-22,000 cSt from Sigma-Aldrich.
Boron oxide nanoparticles ($B_2O_3$, 80 nm) from SkySpring Nanomaterials Inc. Dow Corning Sylgard™ 184 from Silmid Limited.

All materials were used as received.

**Synthesis of self-healing , electrically conducting elastomer:**

Different conducting elastomer compositions were prepared by varying the amount of added DMSO, Triton X-100, drying weight, mixing time, the ratio of insulating phase to conducting phase and composition of the insulating phase. The total weight of PH 1000 and DMSO contributes to a conducting phase.
The compositions which contribute to an insulating phase were, based on the weight of the insulating phase:

84.15 wt.% of PDMS-OH with viscosity 18,000-22,000 cSt
15.00 wt.% of Sylgard 184, wherein the ratio of polymer base (A component) to curing agent (B component) was 5:1,
0.85 wt.% of $B_2O_3$ nanoparticles.

A defined amount of DMSO was added to a defined amount of the PH1000 aqueous dispersion and subjected to a magnetic stirring until a defined drying weight was achieved. A first solution, which contributes the conducting phase, was therefore obtained.
The defined amount of $B_2O_3$ nanoparticles was mixed with mortal to Sylgard 184 polymer base (~30 wt.% of the defined amount) until a homogeneous second solution arise yielding a whitish color. The second solution was added with the defined amount of PDMS-OH, remainder of the polymer base, and defined amount of curing agent and Triton X-100 to the first solution, to form a mixture, while still under continuously magnetic stirring for a defined mixing time. The mixture was then subject to form a film, e.g. by stencil printing to a PET-based release film. The cross-linking of the conducting elastomer film was carried out at elevated temperatures of 70°C. For mechanical and self-healing characterization, freestanding multilayered films were assembled. Electrical properties were measured from the bilayered films.

• Example 2 - amounts of DMSO

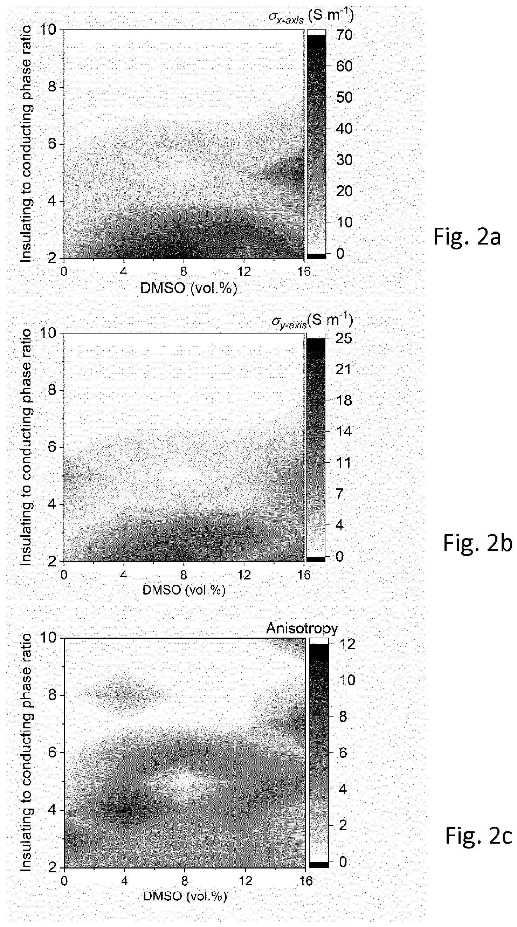

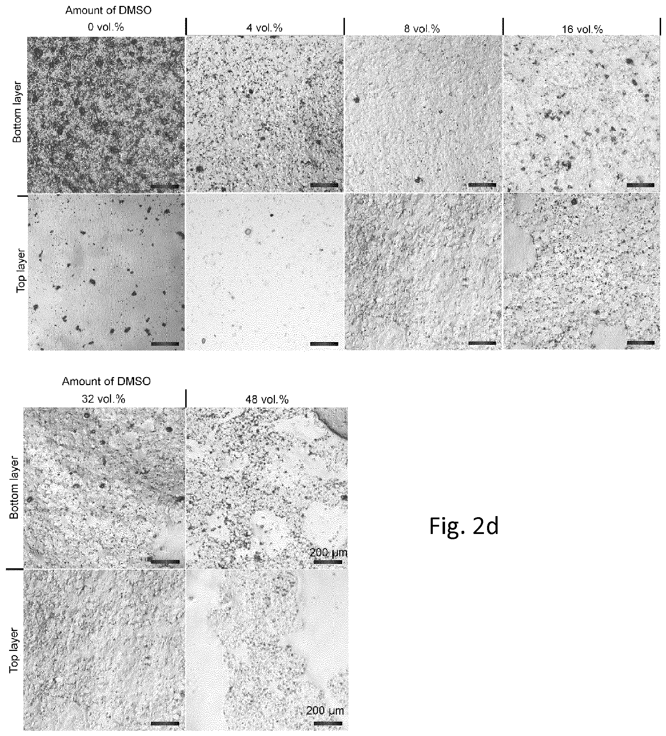

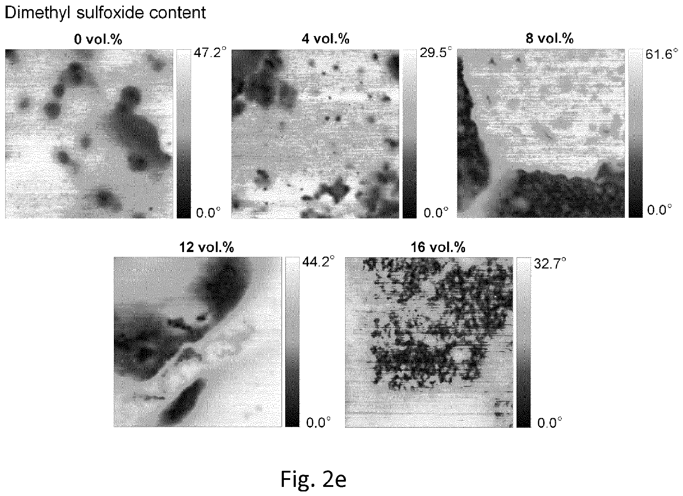

The samples were prepared according to Example 1. The ratio of the insulating and conducting phases has been changed between 2:1 and 10:1 (insulating : conducting) at the same time as the DMSO volume ratio is adjusted between 0 and 16 vol.% (based on PEDOT:PSS volume; with the assumption that the density is close to 1.0 g cm$^{-3}$). The Triton X-100 quantity was fixed to 13.2 % by weight (wt.%) of the aqueous dispersion of PEDOT:PSS by weight. The conductivity (expressed in siemens per meter (S m$^{-1}$)) was measured on a conducting surface in two different directions ( $\sigma_{x\text{-axis}}$, $\sigma\|$ ; vertical conductivity, along nanofibrils; $\sigma$ y-axis, $\sigma^\perp$ ; parallel conductivity, perpendicularly to nanofibrils). as shown in Fig.2a and Fig.2b, respectively, Anisotropy in terms of electrical conductivity is expressed as a ration of vertical to parallel conductivity ( $\sigma$ x-axis/ $\sigma$ y-axis, $\sigma\| / \sigma^\perp$ ), as shown in Fig. 2c.
It is observed that, other factors constant, DMSO content affects the formation of PEDOT-rich nanofibrils and localized heterogeneity of the elastomer. The localized heterogeneity increases with the increasing amount of DMSO, as shown in the optical micrographs in Fig. 2d. In these samples, the ratio of the insulating and conducting phases was fixed to 2:1, with mixing time 15 minutes and drying weight -41%. The localized heterogeneity increases diffusion of the material (i.e., self-healing properties) due to multiple reasons discussed above, and as a consequence, the time taken for self-repair is significantly shorter, while self-healing efficiency can also improve. In the optical micrographs, taken in ambient conditions, as shown in Fig. 2d, the multi-layered conductor is configured so, that the outer layers (top and bottom) are both electrically conducting. The same samples were observed under atomic force microscopy (AFM), as shown in Fig.2e. AFM phase images were measured in tapping mode with pristine elastomers. AFM phase images confirm the morphological changes (for example, degree of phase separation), upon the change of the added DMSO. The phase images show that a higher DMSO content favors the formation of the PEDOT-rich nanofibrils when the amount is close to, or above 16 vol.% or 13 wt.% (in relation to the aqueous solution of PH1000).

• Example 3 - drying weight

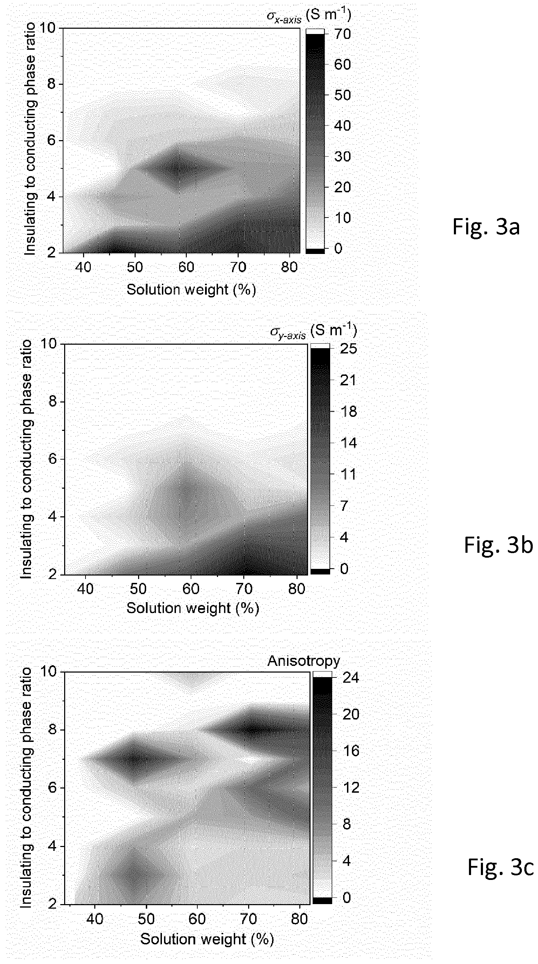

The samples were prepared according to Example 1. The ratio of the insulating and conducting phases has been changed between 2:1 and 10:1 (insulating : conducting) at the same time as the drying weight has been changed between -64% and -18%. The DMSO quantity was fixed to 16 vol.%. The Triton X-100 quantity was 13.2 % by weight (wt.%) of PEDOT:PSS by weight. The conductivity was measured on a conducting surfaces in two different directions and the ratio between them is shown in the right image. In Fig. 3a to Fig. 3c, the solution weight means the weight of the solution after drying. 80% solution weight means that the weight has been reduced by -20% from the initial weight of the PH1000/DMSO solution. As shown in Fig. 3a to Fig. 3c, the drying weight significantly affects the final conductivity of the material due to morphological and structural changes (if other parameters are invariable).

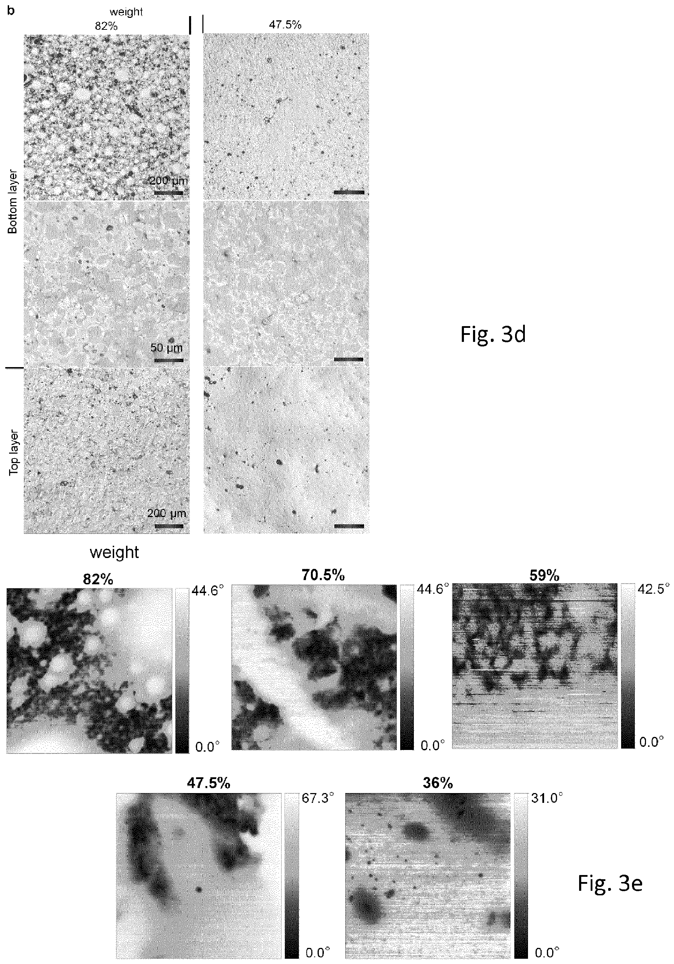

It is observed that, other factors constant, drying weight affects the localized heterogeneity and phase separation of the elastomer. The localized heterogeneity decreases with more drying within the defined range, as shown in the optical micrographs in Fig. 3d. And the less weight lost in the drying is, i.e. less drying, the more degree the phase separation is, i.e. better phase separation, as shown in AFM images in Fig. 3e. It is to be noted that in the in Fig. 3d and Fig. 3e, the values presented refer to the weight of the solution after drying in relation to the initial weight before drying. In other words, the value 82% shown in Fig. 3d means the drying weight, in the expression of the detailed description section of the application and claims, is -18% (obtained by the weight after drying minus the weight before drying and in view of the weight before drying). Thus, the values 70.5%, 59%, 47.5% and 36% shown in Fig. 3d and Fig. 3e, means the drying weights are -29.5%, -41%, -52.5%, -64%, respectively.

• Example 4 - final mixing time

The samples were prepared according to Example 1. The ratio of the insulating and conducting phases was 2:1 (insulating : conducting) with the 16 vol.% DMSO content and drying weight -41%.

It is observed that, other factors constant, the final mixing time after addition of all components affects the conductivity of the resulting elastomer: the conductivity was around 100 S/m with 10 minutes and around 50-70 S/m with 60 minutes mixing time (dependent on the content of Triton X-100).

Also, with longer mixing time, the resulting phase-separation is supressed, and as a consequence, the localized heterogeneity in the conductor is poorer leading to slower self-repair. The sample with 10 minutes mixing time was able to recover ≈105-115% toughness in ≈2minutes after cut-surfaces are in physical contact, while the sample with 60 minutes mixing time was able to recover only ≈25% of toughness in ≈2 minute after cut-surfaces are in physical contact (in ambient conditions). The self-healing efficiencies for other composition are in the range of ≈26-120% in ambient conditions (can be seen in Table 2).

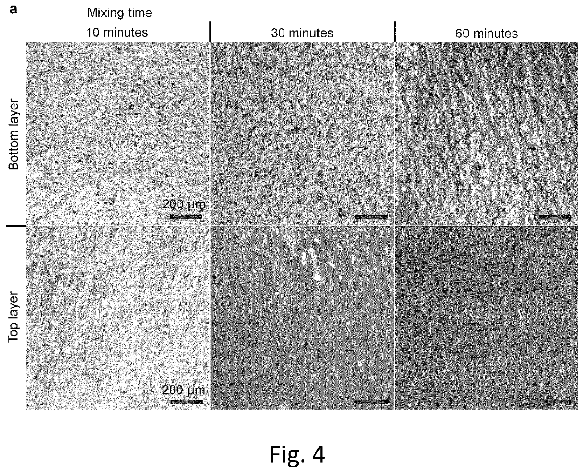

The change in the morphology is also visible in the optical micrographs, as shown in Fig. 4a.

• Example 5 - insulating to conducting ratio

The influence of the ratio of the insulating phase to conducting phase can be seen from Fig. 2a, Fig. 2b, Fig. 2c, Fig. 3a, Fig. 3b, Fig. 3c. The smaller the ratio, the higher the conductivity.

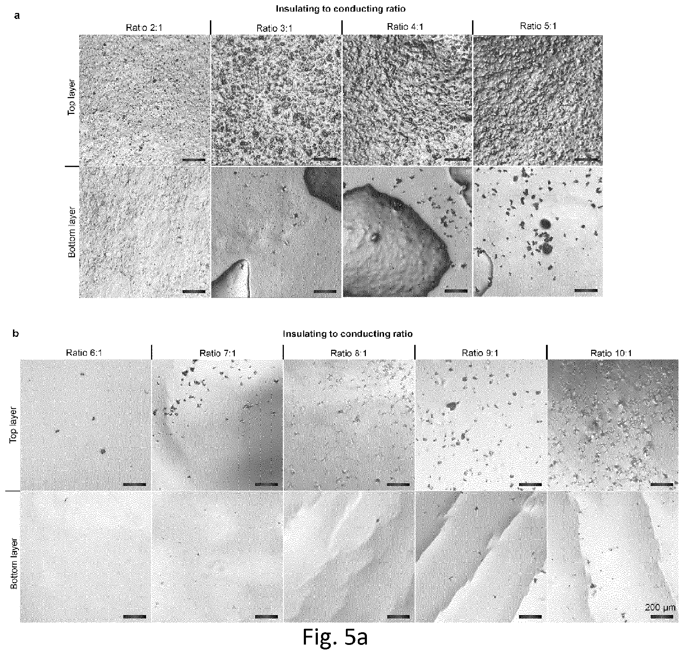

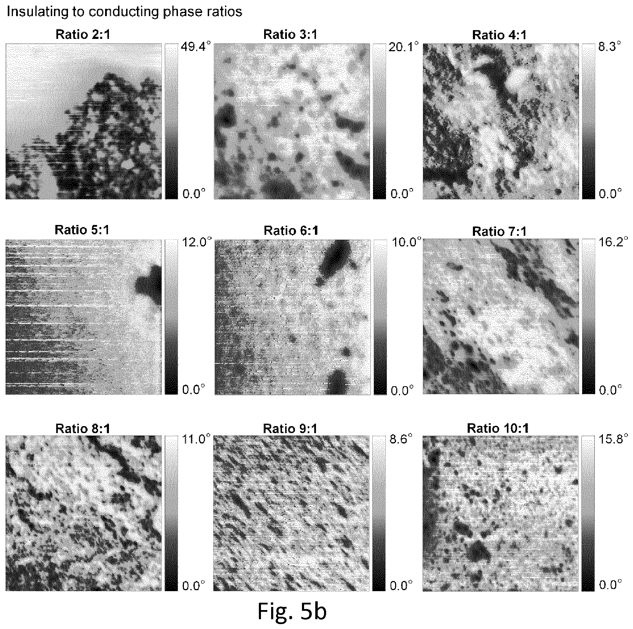

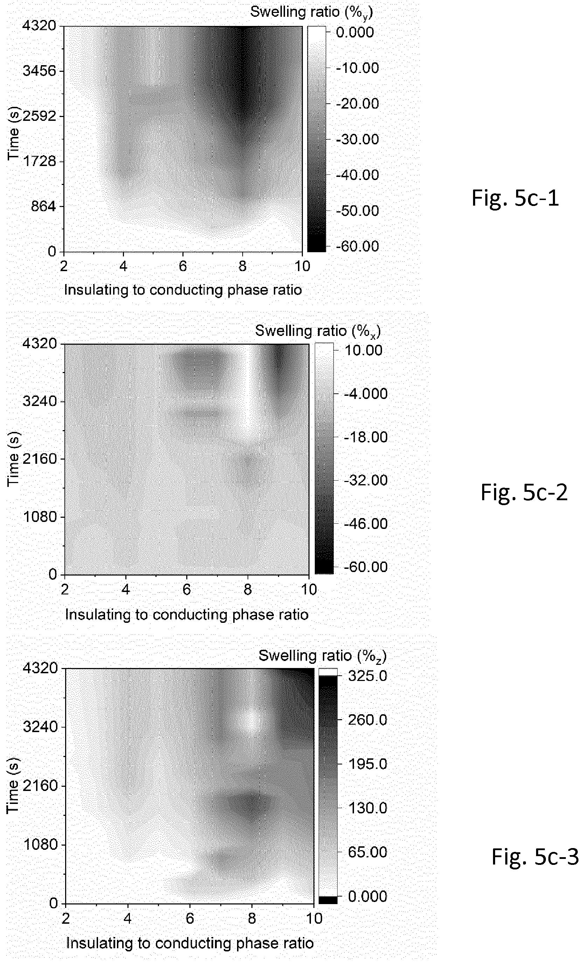

The change in the morphology is also visible in the optical micrographs and AFM phase images, as shown in Fig. 5a and Fig. 5b, wherein the scale bars refer to 200 $\mu$m. The samples were prepared according to Example 1. The ratio of the insulating and conducting phases various from 2:1 to 10:1 (insulating : conducting) with the 16 vol.% DMSO content, 3.7 wt.% Triton X-100, mixing time about 15 minutes and drying weight -41%.

Also, the increased softness and adhesiveness can be seen in the optical micrographs. For instance, visible out-of-plane surface structures (lines) that appear at 8:1 -10:1 is due to compression of the elastomer when it was peeled off from the substrate for the optical imaging. The adhesiveness and anisotropic swelling of the elastomers also increase which are partly result of the increased diffusivity.

Fig. 5c-1 to Fig. 5c-3 show the underwater swelling of conductors in y, x, z-axis directions as a function of insulating to conducting phase ratio and time in seconds. The directions are similar to that with electrical conductivity. For instance, swelling in z-axis expresses thickness change. The swelling ratios are expressed as a mean values. The negative swelling ratio indicates that the size of a specimen decreases from the initial dimensions. Typically, the size of the specimen decreases along x- and y-axis, while the thickness simultaneously increases (positive swelling ratio). The volume of the specimens increases in all cases.

• Example 6 - mechanical properties

The samples were prepared according to Example 1. The ratio of the insulating and conducting phases was 2:1 (insulating : conducting) with the 16 vol.% DMSO content, 1.3 wt.% of Triton X-100, mixing time 15 minutes, and drying weight -41%.

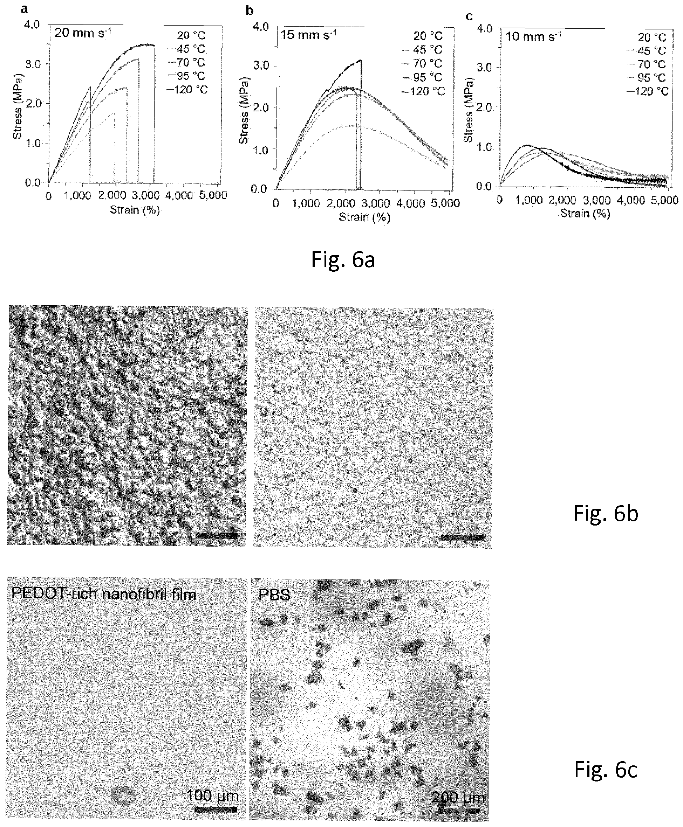

The samples were heated to indicated temperature and then immediately measured with indicated strain rate (10, 15 or 20 mm s$^{-1}$). The results are shown in Fig. 6a, separated graphs of 10, 15 and 20 mm s-1 strain rates, at temperatures between 20 °C - 120 °C.

The multi-layered conductor shows both temperature and speed-induced toughening up to ≈100 °C that is more significant with higher strain rates. As the temperature increases, the mechanical behavior of the dynamics bonds becomes more severe leading to (in some cases) decreased extensibility and toughness. The mechanisms behind the temperature and speed-induced toughening relates to the combination of heterogeneity, phase-separation, nanofibrils and nature of the dynamic bonds. Polyboronsiloxane is known to become elastic with both, increasing temperature or/and shear rate due to both insufficient relaxation and reversible dehydration/hydration process of water-sensitive bonds which may not render the dynamic bonds incapable of dissipating strain energy on deformation through bond dissociation, but result in stiffer junction points in the soft phase as the connections lock their position. Incorporation of nanofibrils (which results in increased diffusivity) may then result in larger conformational entropy change upon deformation through favorable phase-transitions (in consideration of the above-mentioned) as also the modulus mismatches decrease between phases and chain segments with variable stiffnesses. Simply put, the 3D network becomes significantly stronger while it is able to maintain its extensibility. Thus, toughness increases as the material requires both a large force to deform and the extensibility of the conductor is not limited by the absence of bond disassociation (to a certain temperature) due to existing phase-separation and localized heterogeneity. As a result, the multi-layered conductor can achieve remarkable toughness (up to ≈110 MJm$^{-3}$) which exceeds most state-of-the-art self-healing materials and conventional non-healable elastomers (despite containing rigid π-conjugated polymer).

The microstructure of the conductor also changes upon heating, as shown in Fig. 6b for the freestanding multi-layered conductor (the scale in the images is 200 μm). In Fig. 6b, the left image shows the surface of the elastomer after heating to 70°C, and the right image shows the surface in ambient conditions (or upon cooling down to room temperature; approx. 20-22 °C / 20-25 RT%). Reversible phase-rearrangements (in both ways) results in different surface structures as the diffusivity of the dynamic phase changes throughout the volume and is dependent on the predisposed condition (mainly temperature and humidity).

The unique microstructure of the conductor according to the present invention can be seen with comparison of pristine PEDOT-rich nanofibril film and pristine PBS, as shown in Fig. 6c. In the images of Fig. 6c, PEDOT-rich nanofibril film (left) was made with 16 vol.% DMSO content and 1.3 wt.% of Triton X-100, and pristine PBS (right) was made with 18k-22k cSt PDMS-OH, 0.82 wt.% of $B_2O_3$ NPs). Curing temperature was 70 °C for 24 hours. Scale bars 100 um and 200 um, respectively.

• Example 7 - amount of surfactant

The samples were prepared according to Example 1. The ratio of the insulating and conducting phases was 2:1 (insulating : conducting) with the 16 vol.% DMSO content, 1.3 wt.% of Triton X-100, mixing time 15 minutes, and drying weight -41.5%. The amount of Triton X-100 was either 1.3 wt.% or 13 wt.% (denoted as X1.3 and X13, respectively).

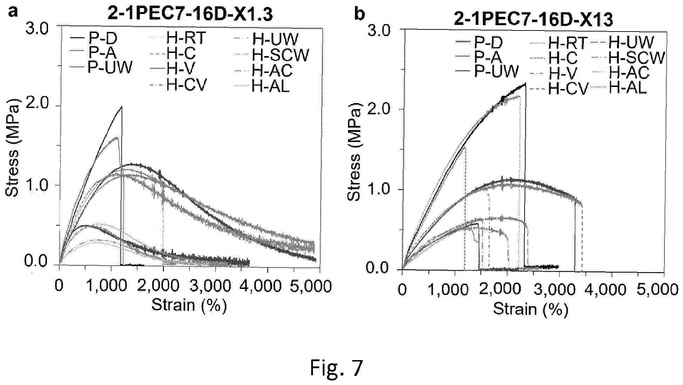

Stress-strain curves were measured with 10 mm s$^{-1}$ strain rate. Self-healing times approximately between 60 to 120 seconds after alignment of cut-surfaces. Cut-surfaces were aligned within 10 seconds in all conditions. Shorter self-healing times for wet conditions. The results are shown in Fig.7.

**List of abbreviations:**

P-D = pristine dry (measured after heating)
P-A = pristine ambient (measured when a sample was kept in ambient conditions)
P-UW = pristine underwater (measured when a sample was kept underwater first)
H-RT = Healing in ambient conditions or room temperature
H-C = Healing in cold (temperature approx. -19C)
H-V = healing in vacuum
H-CV = healing when a sample was kept in cold and placed in a vacuum H-UW = healing underwater
H-SCW = healing in supercooled saline water (26.3 wt.% NaCl water, temperature -19C)
H-AC = healing in acidic condition (pH 2.5)

H-AL = healing in alkaline condition (pH 11.0)

• Tables

**Table 1. Self-healing properties of multilayered conductors with optimal composition in terms of overall performance.** The insulating to conducting phase ratio 2:1, amount of DMSO 16 vol.%, and amount of X-100 1.3 wt. % or 13 wt.%. (Weight after drying was ≈59.5% of the initial weight of the solution and mixing time 15 minutes at the final step).

| Composition | Condition | Toughness (MJm$^{-3}$) | Self-healing efficiency (%) |
|---|---|---|---|
| 2-1PEC7-16D-X1.3 | Pristine ambient | 13.39 ± 3.15 | - |
| | Pristine cold | 33.31 ± 1.70 | - |
| | Pristine underwater | 7.17±0.58 | - |
| | Ambient (≈20-22 °C, 20-25RT%) | 14.13 ± 2.47 | 105.5 |
| | Vacuum | 9.84 ± 2.33 | 73.5 |
| | Cold (-19 °C) | 33.82 ± 1.50 | 101.5 |
| | Cold, vacuum | 31.16 ± 4.58 | 93.6 |
| | Underwater (≈20 °C) | 7.27 ± 0.96 | 101.5 |
| | Supercooled NaCl water (-19 °C) | 6.77 ± 0.35 | 93.2 |
| | Alkaline (pH 11) | 3.14 ± 0.22 | 43.8 |
| | Acidic (pH 2.5 | 3.89 ± 0.41 | 54.3 |
| 2-1PEC7-16D-X13 | Pristine ambient | 34.64 ± 0.64 | - |
| | Pristine cold | 18.79 ± 4.32 | - |
| | Pristine underwater | 7.02 ± 1.33 | - |
| | Ambient (≈20-22 °C, 20-25RT%) | 39.84 ± 8.80 | 115.0 |
| | Vacuum | 11.20 ± 3.87 | 32.3 |
| | Cold (-19 °C) | 10.32 ± 0.18 | 54.9 |
| | Cold, vacuum | 22.36 ± 4.53 | 119.0 |
| | Underwater (≈20 °C) | 5.07 ± 0.52 | 72.2 |
| | Supercooled NaCl water (-19 °C) | 3.61 ± 0.87 | 51.4 |
| | Alkaline (pH 11) | 6.23 ± 0.89 | 88.7 |
| | Acidic (pH 2.5) | 7.57 ± 1.76 | 107.8 |

Note: Self-healing properties were compared to pristine specimens in specific conditions (ambient, cold, or underwater) due to effect of temperature and/or humidity to the mechanical properties. Toughness is expressed as a mean ± STD (n ≥ 3). Self-healing times were approximately 120 seconds in dry conditions and 60 seconds in wet conditions.

**Table 2. Mechanical and self-healing properties for multilayered conductors with varied compositions. Other processing parameters**

| Composition | Mechanical properties | | | | Self-healing properties | |
|---|---|---|---|---|---|---|
| | $E$ (MPa) | $\sigma_{max}$ (MPa) | $\varepsilon_{break}$ (%) | $U_T$ (MJm$^{-3}$) | $U_{T-healed}$ (MJm$^{-3}$) | Efficiency (%) |
| **1-1PEC7-16D-X** | **0.44** | 2.10 | 600 | 6.6 | **1.7** | **25.9** |
| **2-1PEC7-0D-X13** | **0.30** | **2.51** | **980** | **12.9** | **2.0** | **11.2** |
| **2-1PEC6-0D-X13** | 0.21 | **1.72** | **890** | 7.7 | **2.2** | **29.8** |
| 2-1PEC7-0D-X1.3 | 0.19 | 0.48 | 870 | 3.2 | | |
| 2-1PEC7-16D-X13 | 0.21 | 2.34 | 2340 | 33.9 | 39.8 | 115.0 |

(continued)

| Composition | Mechanical properties | | | | Self-healing properties | |
| --- | --- | --- | --- | --- | --- | --- |
| | $E$ (MPa) | $\sigma_{max}$ (MPa) | $\varepsilon_{break}$ (%) | $U_T$ (MJm$^{-3}$) | $U_{T\text{-healed}}$ (MJm$^{-3}$) | Efficiency (%) |
| **2-1-PEC7-16D-X13 (60 min)** | **0.36** | **2.75** | **1540** | **24.7** | 6.1 | **24.6** |
| **2-1PEC6-16D-X** | **0.26** | **1.93** | **780** | **9.2** | **2.2** | **23.2** |
| **2-1PEC7-32D-X** | **0.22** | **3.2** | **2090** | 21.0 | **9.6** | **45.5** |
| 2-1PEC7-48D-X | 0.19 | 0.88 | 4910 | 18.9 | 18.3 | 96.3 |
| 3-1PEC7-16D-X | 0.21 | 0.90 | 2980 | 22.6 | 19.9 | 88.3 |
| 4-1PEC7-16D-X | 0.13 | 0.87 | 4340 | 28.1 | 32.9 | 118.9 |
| **5-1PEC7-16D-X** | **0.18** | **1.07** | **4960** | **27.7** | **17.8** | **64.4** |
| 6-1PEC7-16D-X | 0.19 | 1.52 | 2220 | 24.8 | 26.7 | 107.7 |
| 7-1PEC7-16D-X | 0.10 | 0.90 | 4950 | 29.0 | 25.9 | 89.4 |
| **8-1PEC7-16D-X** | **0.17** | **1.15** | **2490** | **21.9** | **5.7** | 26.1 |
| 9-1PEC7-16D-X | 0.22 | 1.54 | 2380 | 26.2 | 31.4 | 120.1 |
| 10-1PEC7-16D-X | 0.15 | 0.64 | 2940 | 14.3 | 14.6 | 102.1 |

Notes: Mechanical properties were measured with 10 mm s$^{-1}$ strain rate in ambient conditions directly after cross-linking (before exposure to ambient conditions for longer times).

$E$ = Young's modulus (expressed in MPa), $\sigma_{max}$ = *ultimate stress (expressed in MPa)*, $\varepsilon_{break}$ = *elongation at break (expressed in* %), $U_T$ = toughness (i.e., area under stress-strain curve; expressed in MJm$^{-3}$) Self-healing efficiency expressed as a ratio of recovered toughness in damage specimen to that of a pristine specimen.

The values expressed as mean (n $\geq$ 3).

**Claims**

1. A method for manufacturing a self-healing, electrically conducting elastomer (400), comprising

   - providing a first mixture (M1') comprising PEDOT:PSS and a solvent (O1), said first mixture contributing to an electrically conducting phase of the elastomer,
   - providing separately following components, which contribute to an electrically insulating phase of the elastomer, with respect to the total weight of the electrically insulating phase:

     • 0.1 - 5 wt.% of boron trioxide (B$_2$O$_3$),
     • 65 - 90 wt.% of hydroxyl-terminated polydimethylsiloxane (PDMS-OH), and
     • 5-30 wt.%, when measured in combined, of polysiloxane precursors (201), being

       • a first composition (201a) comprising a siloxane base, and
       • a second composition (201b) comprising a siloxane crosslinker, wherein the ratio by weight of the first composition (201a) and the second composition (201b) is 1:1 to 50:1,

   - mixing the B$_2$O$_3$, the PDMS-OH, a surfactant (S1), the first mixture (M1'), and the polysiloxane precursors (201), thereby obtaining a second mixture (M2),
   - allowing reaction to take place in the second mixture (M2) by setting the second mixture (M2) at an elevated temperature in a range of 50 °C - 150 °C, thereby obtaining the elastomer (400).

2. The method according claim 1, wherein the first mixture (M1') is obtained by

   - providing an aqueous dispersion (P1) comprising PEDOT:PSS,
   - adding the solvent (O1) into the aqueous dispersion (P1), thereby obtaining a mixture (M1),
   - drying the mixture (M1), thereby obtaining the first mixture (M1').

3. The method according claim 2,

19

wherein in the mixture (M1), the amount of the solvent (O1) is more than 0 wt.%, for example up to 32 wt.% and preferably 13 wt.%, based on the weight of the aqueous dispersion (P1); and/or

wherein the first mixture (M1'), compared to the weight of the mixture (M1), has a decreased weight in a range of from -64 wt.% to below 0 wt.%, preferably from -60 wt.% to -15 wt.%, more preferably between from -40 wt.% to -20 wt.%, most preferably between from -20 wt.% to -35 wt.%, expressed according to the formula below

$$(\text{weight of the first mixture (M1')} - \text{weight of the mixture (M1)}) \div (\text{weight of the mixture (M1)}) \times 100\%;$$

and/or

wherein PEDOT:PSS has a dry matter content in a range of 1.1 - 1.3 wt.% based on the weight of the aqueous solution (P1); and/or

wherein PEDOT:PSS has a PEDOT to PSS ratio in a range of 1:2.5 - 1:20; and/or

wherein the amount of the surfactant (S1) is at least 0.1 wt.%, for example up to 15 wt.%, based on the weight of the aqueous dispersion (P1) ; and/or

wherein the aqueous dispersion (P1) further comprises one-dimensional nanomaterial, such as metallic nanowires or carbon nanotubes, preferably the one-dimensional nanomaterial is COOH-functionalized carbon nanotubes preferably in an amount of more than 0 and up to 3 wt.%, more preferably 0.75 - 1.5 wt.%, based on the weight of the aqueous dispersion (P1).

4. The method according any of preceding claims,
wherein the mixing is for at least 5 minutes, for example up to 90 minutes, preferably up to 60 minutes; more preferably, the homogeneously mixing is in a range of 10 - 20 minutes.

5. The method according any of preceding claims,

wherein the solvent (O1) further comprises a water-soluble compound comprising acidic anions, such as ionic salt such as lithium bis(trifluoromethylsulphonyl)imide (LiTFSI); or

wherein the solvent (O1) is an organic solvent, preferably a polar solvent, for example DMSO, ethylene glycol (EG), tetrahydrofuran (THF), or glycerol.

6. The method according any of preceding claims,

wherein the $B_2O_3$ is in an amount of 0.10 - 3.00 wt.%, preferably 0.65 - 1.90 wt.%, more preferably 0.75 - 1.45 wt.%, for example 0.85 wt.%, based on the total weight of the electrically insulating phase; and/or

wherein the PDMS-OH is in an amount of 69 - 89.5 wt.%, for example 69.3 - 89.1 wt.%, preferably 75 - 88 wt.%, more preferably 77 - 86 wt.%, for example 84 wt.%, based on the total weight of the electrically insulating phase; and/or

wherein the polysiloxane precursors combined is in an amount of 10-20 wt.%, preferably 13 - 17 wt.%, for example 15 wt.%, based on the total weight of the electrically insulating phase, and wherein the ratio by weight of the first composition (201a) and the second composition (201b) is 2.5:1 to 10:1; and/or

wherein the PDMS-OH has a kinematic viscosity ranging from 850 - 25000 cSt, more preferably 18000-22000 cSt, at 25 °C, measured according to standard ASTM D2196-20; and/or

wherein the $B_2O_3$ is in a form of nanoparticles having a number-average diameter of 50 - 200 nm, preferably 80 - 100 nm, measured microscopically, for example by using electron microscopy, such as SEM.

7. The method according any of preceding claims, wherein, with respect to the total weight the $B_2O_3$, the PDMS-OH and the polysiloxane precursors, the $B_2O_3$ is 1 wt.% and has an average diameter of 80 nm measured microscopically, for example by using electron microscopy, such as SEM, the PDMS-OH is 85 wt.% and has a kinematic viscosity of 18,000-22,000 cSt at 25 °C measured according to standard ASTM D2196-20, the polysiloxane precursors (201) is 14 wt.%, wherein the ratio by weight of the first composition (201a) and the second composition (201b) is 5:1; and wherein the reaction is taken place at 70 °C.

8. The method according any of preceding claims, wherein
the ratio of the total weight of the electrically insulating phase, to the total weight of the electrically conducting phase, is between 1:1 to 10:1, preferably 2:1.

9.  A self-healing, electrically conducting elastomer (400) in the form of a multilayered film, comprising:

    - a first layer comprising an electrically conducting phase, comprising PEDOT:PSS; and
    - a second layer comprising an electrically insulating phase, comprising a polyborosiloxane-based polymer and a polydimethylsiloxane-based polymer; preferably, wherein the self-healing, electrically conducting elastomer (400) is obtainable by the method according to any of claims 1-8.

10. The self-healing, electrically conducting elastomer (400) in the form of a multilayered film according to claim 9, wherein the electrically insulating phase comprises an interpenetrating polymer network of polyborosiloxane-based polymer and a polydimethylsiloxane-based polymer.

11. The self-healing, electrically conducting elastomer (400) in the form of a multilayered film according to claim 9 or 10, further comprises one-dimensional nanomaterial, such as metallic nanowires or carbon nanotubes, preferably silver nanowires or copper nanowires or COOH-functionalized carbon nanotubes.

12. The self-healing, electrically conducting elastomer (400) in the form of a multilayered film according to any of the claims 9 - 11, having at least one of the following properties:

    - an anisotropic electrical conductivity in a range of $10^{-8}$ - 10 S cm$^{-1}$ , such as $10^{-5}$ - $10^{-2}$ S cm$^{-1}$; and/or an electrical anisotropy in a range of 0.5 - 25;
    - anisotropic swelling underwater;
    - capability of being stretched more than 20 times of initial length and recover with insignificant residual strain in range of 0 to 100%;
    - recovers of 10-120% of toughness after mechanical damage in ambient conditions in 10-200 seconds;
    - optical transmittance of the conductor increases with strain;
    - capability to self-heal in low or high atmospheric pressures, for example, from 6 to 110 kPa, and temperatures ranging from -100° to 200 °C, saline, acidic and alkaline conditions, underwater and in combinations of these;
    - recovers $\approx$100% of conductivity after mechanical damage;
    - temperature and speed-induced toughening with toughness in the range of more than 1.0, such as up to 100 MJm$^{-3}$, for example 10 - 70 MJm$^{-3}$, or more than 100 MJm$^{-3}$;
    - Young's modulus in range of 0.1 - 0.5 MPa with 1 - 20 mm s$^{-1}$ strain rate;
    - stretchability in the range of more than 500 strain with 10 mm s$^{-1}$ strain rate, for example up to 5,000% strain or more than 5,000% strain.

13. An electrically conductive self-healing polymer foam, comprising a porous scaffold, for example polyurethane foam, coated or impregnated with a composition comprising PEDOT:PSS and polyborosiloxane-based polymer, preferably an interpenetrating polymer network of polyborosiloxane-based polymer and a polydimethylsiloxane-based polymer.

14. Use of the self-healing, electrically conducting elastomer (400) according to any of claims 9 - 12 or obtainable by the method according to any of claims 1-8, in the soft electronics, or additive manufacturing process.

Fig. 1a

Fig. 1b

Fig. 2a

Fig. 2b

Fig. 2c

Fig. 2d

Dimethyl sulfoxide content

Fig. 2e

Fig. 3a

Fig. 3b

Fig. 3c

Fig. 3d

Fig. 3e

Fig. 4

a

Insulating to conducting ratio

| Ratio 2:1 | Ratio 3:1 | Ratio 4:1 | Ratio 5:1 |

Top layer

Bottom layer

b

Insulating to conducting ratio

| Ratio 6:1 | Ratio 7:1 | Ratio 8:1 | Ratio 9:1 | Ratio 10:1 |

Top layer

Bottom layer

200 µm

## Fig. 5a

Insulating to conducting phase ratios

Fig. 5b

Fig. 5c-1

Fig. 5c-2

Fig. 5c-3

EP 4 245 796 A1

Fig. 6a

Fig. 6b

PEDOT-rich nanofibril film    PBS

Fig. 6c

33

Fig. 7

Europäisches
Patentamt

European
Patent Office

Office européen
des brevets

# EUROPEAN SEARCH REPORT

**Application Number**

EP 22 16 2435

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2020/363273 A1 (HSIEH YOU-LO [US] ET AL) 19 November 2020 (2020-11-19)<br>* abstract *<br>* claims 1-10 *<br>* page 4, paragraph 55 - page 5, paragraph 58 *<br>* page 5, paragraph 59-60 *<br>* page 7, paragraph 74-75 * | 1-14 | INV.<br>C08J3/24<br>C08G61/12<br>C08J5/18<br>C08L25/18<br>C08L65/00<br>H01L51/00 |
| Y | KEE SEYOUNG ET AL: "Self-Healing and Stretchable 3D-Printed Organic Thermoelectrics",<br>ADVANCED FUNCTIONAL MATERIALS,<br>vol. 29, no. 51,<br>9 December 2019 (2019-12-09), page 1905426, XP055952235,<br>DE<br>ISSN: 1616-301X, DOI: 10.1002/adfm.201905426<br>Retrieved from the Internet:<br>URL:https://onlinelibrary.wiley.com/doi/full-xml/10.1002/adfm.201905426><br>* the whole document * | 1-14 | |
| Y | & KEE SEYOUNG ET AL: "Self-Healing and Stretchable 3D-Printed Organic Thermoelectrics_SI",<br>ADVANCED FUNCTIONAL MATERIALS,<br>vol. 29, no. 51,<br>21 October 2019 (2019-10-21), pages 1-12, XP055952783,<br>DE<br>ISSN: 1616-301X, DOI: 10.1002/adfm.201905426<br>Retrieved from the Internet:<br>URL:https://onlinelibrary.wiley.com/doi/full-xml/10.1002/adfm.201905426><br>* the whole document * | 1-14 | TECHNICAL FIELDS SEARCHED (IPC)<br><br>C08J<br>C09J<br>C08G<br>C08L<br>H01L |

-/--

The present search report has been drawn up for all claims

| Place of search | Date of completion of the search | Examiner |
|---|---|---|
| Munich | 18 August 2022 | Schlembach, Sandra |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

**EP 22 16 2435**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | QU PEIYAO ET AL: "A Highly Stretchable, Self-Healing Elastomer with Rate Sensing Capability Based on a Dynamic Dual Network", APPLIED MATERIALS & INTERFACES, vol. 13, no. 7, 24 February 2021 (2021-02-24), pages 9043-9052, XP055952447, US ISSN: 1944-8244, DOI: 10.1021/acsami.1c00282 * the whole document * | 1-14 | |
| Y | CHEN CHAO ET AL: "Soft double-network polydimethylsiloxane: fast healing of fracture toughness", JOURNAL OF MATERIALS CHEMISTRY A, vol. 10, no. 21, 28 February 2022 (2022-02-28), pages 11667-11675, XP055952442, GB ISSN: 2050-7488, DOI: 10.1039/D2TA00887D Retrieved from the Internet: URL:http://pubs.rsc.org/en/content/article pdf/2022/TA/D2TA00887D> * the whole document * | 1-14 | |

-/--

TECHNICAL FIELDS
SEARCHED (IPC)

The present search report has been drawn up for all claims

| Place of search | Date of completion of the search | Examiner |
|---|---|---|
| Munich | 18 August 2022 | Schlembach, Sandra |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

# EUROPEAN SEARCH REPORT

Application Number

EP 22 16 2435

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | YAGCI ÖZLEM ET AL: "Effect of boric acid doped PEDOT:PSS layer on the performance of P3HT:PCBM based organic solar cells", SYNTHETIC METALS, vol. 212, 1 February 2016 (2016-02-01), pages 12-18, XP055952231, CH ISSN: 0379-6779, DOI: 10.1016/j.synthmet.2015.11.010 Retrieved from the Internet: URL:https://nanoafm.ru/images/literature/e zafm/ezAFM6.pdf> * the whole document * ----- | 1-14 | |
| A | XIN XING ET AL: "Effects of conductivity-enhancement reagents on self-healing properties of PEDOT:PSS films", SYNTHETIC METALS, ELSEVIER SEQUOIA LAUSANNE, CH, vol. 268, 8 July 2020 (2020-07-08), XP086285095, ISSN: 0379-6779, DOI: 10.1016/J.SYNTHMET.2020.116503 [retrieved on 2020-07-08] * the whole document * ----- | 1-14 | TECHNICAL FIELDS SEARCHED (IPC) |
| T | Rcs: "Journal of Materials Chemistry A", , 1 January 2022 (2022-01-01), pages 1-10, XP055952457, Retrieved from the Internet: URL:https://www.rsc.org/journals-books-dat abases/about-journals/journal-of-materials -chemistry-a [retrieved on 2022-08-17] * the whole document * ----- | 1-14 | |

The present search report has been drawn up for all claims

| Place of search | Date of completion of the search | Examiner |
|---|---|---|
| Munich | 18 August 2022 | Schlembach, Sandra |

EPO FORM 1503 03.82 (P04C01)

## ANNEX TO THE EUROPEAN SEARCH REPORT
## ON EUROPEAN PATENT APPLICATION NO.

EP 22 16 2435

This annex lists the patent family members relating to the patent documents cited in the above-mentioned European search report.
The members are as contained in the European Patent Office EDP file on
The European Patent Office is in no way liable for these particulars which are merely given for the purpose of information.

18-08-2022

| Patent document cited in search report | Publication date | Patent family member(s) | Publication date |
|---|---|---|---|
| US 2020363273 A1 | 19-11-2020 | NONE | |

For more details about this annex : see Official Journal of the European Patent Office, No. 12/82

EPO FORM P0459